(19) Europäisches Patentamt / European Patent Office / Office européen des brevets

(11) **EP 4 443 476 A1**

(12) # EUROPEAN PATENT APPLICATION
published in accordance with Art. 153(4) EPC

(43) Date of publication:
**09.10.2024 Bulletin 2024/41**

(21) Application number: **22954220.4**

(22) Date of filing: **08.08.2022**

(51) International Patent Classification (IPC):
**H01L /(2006.01)**

(86) International application number:
**PCT/CN2022/110849**

(87) International publication number:
**WO 2024/031240 (15.02.2024 Gazette 2024/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Boe Technology Group Co., Ltd.**
  **Beijing 100015 (CN)**
- **Chengdu BOE Optoelectronics Technology Co., Ltd.**
  **Chengdu, Sichuan 611731 (CN)**

(72) Inventors:
- **LU, Yanwei**
  **Beijing 100176 (CN)**
- **JI, Fengli**
  **Beijing 100176 (CN)**
- **ZHOU, Zhenli**
  **Beijing 100176 (CN)**
- **QIN, Chengjie**
  **Beijing 100176 (CN)**
- **YAN, Zhuoran**
  **Beijing 100176 (CN)**
- **ZHOU, Hongjun**
  **Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE, MANUFACTURING METHOD THEREFOR, AND DISPLAY APPARATUS**

(57) A display substrate, a manufacturing method therefor, and a display apparatus. The display substrate comprises a substrate (101), a driving circuit layer (102) and a light-emitting structure layer (103). The driving circuit layer (102) comprises a plurality of circuit units, each circuit unit at least comprising a pixel driving circuit, and the pixel driving circuits at least comprising storage capacitors (40) and compensation transistors (T2). By means of a first connection electrode (41), a first electrode of each compensation transistor (T2) is connected to a first plate of a storage capacitor (40). The light-emitting structure layer (103) comprises a plurality of light-emitting units, each light-emitting unit at least comprising an anode (50), and the anodes (50) being connected to the pixel driving circuits. The orthographic projection of the anode (50) of at least one light-emitting unit on the substrate (101) at least partially overlaps with the orthographic projection of the first connection electrode (41) of at least one circuit unit on the substrate. The shapes of the first connection electrodes (41) of at least two circuit units are different.

FIG. 7

EP 4 443 476 A1

**Description**

Technical Field

The present disclosure relates to, but is not limited to, the field of display technologies, and particularly to a display substrate and a manufacturing method therefor, and a display device.

Background

An Organic Light Emitting Diode (OLED) and a Quantum dot Light Emitting Diode (QLED) are active light emitting display devices and have advantages such as self-luminescence, a wide viewing angle, a high contrast ratio, low power consumption, an extremely high response speed, lightness and thinness, flexibility, and a low cost. With constant development of display technologies, a flexible display apparatus (Flexible Display) in which an OLED or a QLED is used as a light emitting device and signal control is performed through a Thin Film Transistor (TFT) has become a mainstream product in the field of display at present.

Summary

The following is a summary of subject matter described herein in detail. The summary is not intended to limit the scope of protection of the claims.

In one aspect, the present disclosure provides a display substrate including a drive circuit layer provided on a base substrate, and a light emitting structure layer provided on a side of the drive circuit layer away from the base substrate; wherein the drive circuit layer includes a plurality of circuit units, a circuit unit at least includes a pixel drive circuit, the pixel drive circuit at least includes a storage capacitor and a compensation transistor, a first electrode of the compensation transistor is connected to a first electrode plate of the storage capacitor through a first connection electrode; the light emitting structure layer includes a plurality of light emitting units, a light emitting unit at least include an anode, and the anode is connected to the pixel drive circuit; an orthographic projection of the anode of at least one light emitting unit on the base substrate at least partially overlaps an orthographic projection of the first connection electrode of at least one circuit unit on the base substrate, and first connection electrodes of at least two circuit units have different shapes.

In an exemplary embodiment, the first connection electrode includes an electrode body portion and an electrode compensation portion, the electrode body portion includes a first end connected to the first electrode plate of the storage capacitor and a second end connected to the first electrode of the compensation transistor, the electrode compensation portion is provided on a side of the first end away from the second end; electrode body portions of at least two circuit units have a same shape, and electrode compensation portions of at least two circuit units have different shapes.

In an exemplary embodiment, a plurality of circuit units form a plurality of unit rows and a plurality of unit columns, an unit row includes a plurality of circuit units sequentially provided in a first direction, an unit column includes a plurality of circuit units sequentially provided in a second direction, the first direction intersects the second direction; and in at least one unit column, first connection electrodes of at least two circuit units have a same shape.

In an exemplary embodiment, in at least one unit row, the plurality of circuit units may at least include a first circuit unit, a second circuit unit and a third circuit unit, a pixel drive circuit of the first circuit unit is connected to a red light emitting unit emitting red light, a pixel drive circuit of the second circuit unit is connected to a blue light emitting unit emitting blue light, a pixel drive circuit of the third circuit unit is connected to a green light emitting unit emitting green light, and first connection electrodes in the first circuit unit, the second circuit unit, and the third circuit unit have different shapes.

In an exemplary embodiment, electrode body portions in the first circuit unit, the second circuit unit, and the third circuit unit have a same shape, and electrode compensation portions in the first circuit unit, the second circuit unit, and the third circuit unit have different shapes.

In an exemplary embodiment, a first connection electrode of the first circuit unit has a first length, a first connection electrode of the second circuit unit has a second length, and a first connection electrode of the third circuit unit has a third length. The first length, the second length and the third length are different, and the first length, the second length and the third length are dimensions of first connection electrodes in the second direction.

In an exemplary embodiment, the second length is greater than the first length, and the second length is greater than the third length.

In an exemplary embodiment, the third length is greater than the first length.

In an exemplary embodiment, the anode of at least one light emitting unit includes an anode body portion, an anode connection portion and an anode compensation portion, the anode connection portion is configured to be connected to the pixel drive circuit, and the anode compensation portion is provided on a side of the anode connection portion away from the anode body portion.

In an exemplary embodiment, in at least one circuit unit, an orthographic projection of the anode compensation portion on the base substrate at least partially overlaps an orthographic projection of the electrode compensation portion of the first connection electrode on the base substrate.

In an exemplary embodiment, in at least one circuit unit, an orthographic projection of the anode compensation portion on the base substrate at least partially overlaps an orthographic projection of the electrode body portion of the first connection electrode on the base substrate.

In an exemplary embodiment, in at least one circuit unit, an orthographic projection of the anode body portion on the base substrate at least partially overlaps an orthographic projection of the first connection electrode on the base substrate.

In an exemplary embodiment, in at least one circuit unit, an orthographic projection of the anode body portion on the base substrate does not overlap an orthographic projection of the first connection electrode on the base substrate.

In an exemplary embodiment, in at least one circuit unit, the anode is provided with a compensation notch configured to reduce an overlapping area of the anode and the first connection electrode.

In an exemplary embodiment, the anode further includes a protrusion provided on a side of the anode body portion away from the anode connection portion, an orthographic projection of the protrusion on the base substrate at least partially overlaps an orthographic projection of the first connection electrode on the base substrate, and the compensation notch is provided on the protrusion.

In an exemplary embodiment, the compensation notch includes a groove provided on an edge of the protrusion, and an orthographic projection of the groove on the base substrate at least partially overlaps an orthographic projection of the first connection electrode on the base substrate.

In an exemplary embodiment, on a plane perpendicular to the display substrate, the drive circuit layer includes a semiconductor layer, a first conductive layer, a second conductive layer and a third conductive layer that are sequentially provided on the base substrate; the semiconductor layer at least includes an active layer of the compensation transistor, the first conductive layer at least includes the first electrode plate of the storage capacitor and a gate electrode of the compensation transistor, and the second conductive layer at least includes the second electrode plate of the storage capacitor, and the third conductive layer at least includes the first connection electrode.

In another aspect, the present disclosure further provides a display device, including the display substrate described above.

In another aspect, the present disclosure further provides a manufacturing method for a display substrate, including: forming a drive circuit layer on a base substrate, wherein the drive circuit layer includes a plurality of circuit units, a circuit unit at least includes a pixel drive circuit, the pixel drive circuit at least includes a storage capacitor and a compensation transistor, a first electrode of the compensation transistor is connected to a first electrode plate of the storage capacitor through a first connection electrode, and first connection electrodes of at least two circuit units have different shapes; and forming a light emitting structure layer on the drive circuit layer, wherein the light emitting structure layer includes a plurality of light emitting units, a light emitting unit at least includes an anode, and the anode is connected to the pixel drive circuit; and an orthographic projection of the anode of at least one light emitting unit on the base substrate at least partially overlaps an orthographic projection of the first connection electrode of at least one circuit unit on the base substrate.

After the drawings and the detailed description are read and understood, other aspects may be comprehended.

Brief Description of Drawings

The accompany drawings are used to provide further understanding of the technical solution of the present disclosure, and form a part of the specification. The accompany drawings and embodiments of the present disclosure are adopted to explain the technical solution of the present disclosure, and do not form limits to the technical solution of the present disclosure.

FIG. 1 is a schematic diagram of a structure of a display device.

FIG. 2 is a schematic diagram of a planar structure of a display substrate;

FIG. 3 is a schematic diagram of a sectional structure of a display substrate;

FIG. 4 is a schematic diagram of an equivalent circuit of a pixel drive circuit.

FIG. 5 is a schematic diagram of an arrangement of circuit units according to an exemplary embodiment of the present disclosure.

FIG. 6 is a schematic diagram of an arrangement of light emitting units according to an exemplary embodiment of the present disclosure.

FIG. 7 is a schematic diagram of a structure of a display substrate according to an exemplary embodiment of the present disclosure.

FIG. 8 is a schematic diagram of a display substrate after a pattern of a semiconductor layer is formed according to the present disclosure.

FIG. 9A and 9B are schematic diagrams of a display substrate after a pattern of a first conductive layer is formed according to the present disclosure.

FIG. 10A and 10B are schematic diagrams of a display substrate after a pattern of a second conductive layer is formed according to the present disclosure.

FIG. 11 is a schematic diagram of a display substrate after a pattern of a fourth insulating layer is formed according to the present disclosure.

FIGS. 12A and 12B are schematic diagrams of a display substrate after a pattern of a third conductive layer is formed according to the present disclosure.

FIG. 13 is a schematic diagram of a display substrate after a pattern of a planarization layer is formed according to the present disclosure.

FIGS.14A and 14B are schematic diagrams of a display substrate after a pattern of an anode conductive layer is formed according to the present disclosure.

FIGS. 15A to 15C are planar schematic diagrams of an anode according to the present disclosure.

FIGS. 16A to 16C are schematic diagrams of a structure of another display substrate according to an exemplary embodiment of the present disclosure.

FIGS. 17A to 17C are schematic diagrams of a structure of yet another display substrate according to an exemplary embodiment of the present disclosure.

FIGS. 18A to 18B are schematic diagrams of a structure of still another display substrate according to an exemplary embodiment of the present disclosure.

Reference signs are described as follows.

| | | |
|---|---|---|
| 11-first active layer; | 12-second active layer; | 13-third active layer; |
| 14-fourth active layer; | 15-fifth active layer; | 16-sixth active layer; |
| 17-seventh active layer; | 21-first scan signal line; | 22-second scan signal line |
| 23-light emitting control signal line; | 24-first electrode plate; | 31-initial signal line; |
| 32-second electrode plate; | 33-electrode plate connection line; | 34-shielding electrode; |
| 35-opening; | 40-storage capacitor; | 41-first connection electrode; |
| 41-1-electrode body portion; | 41-2-electrode compensation portion; | 42-second connection electrode; |
| 43-third connection electrode; | 44-data signal line; | 45-first power supply line; |
| 50-anode; | 50-1-anode body portion; | 50-2-anode compensation portion; |
| 51-first anode; | 52-second anode; | 53-third anode; |
| 54-fourth anode; | 55-fifth anode; | 71-first protrusion; |
| 72-second protrusion; | 73-third protrusion; | 74-fourth projection; |

(continued)

| | | |
|---|---|---|
| 75-fifth projection; | 76-sixth projection; | 81-first anode compensation portion; |
| 82-second anode compensation portion; | 83-third anode compensation portion; | 90-compensation notch; |
| 101-base substrate; | 102-drive circuit layer; | 103-light emitting structure layer; |
| 104-encapsulation structure layer. | | |

Detailed Description

To make the objectives, technical solutions, and advantages of the present disclosure clearer, the embodiments of the present disclosure will be described in detail below in combination with the accompany drawings. It is to be noted that the implementations may be implemented in various forms. Those of ordinary skills in the art can easily understand such a fact that modes and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other in case of no conflicts.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. The number of pixels in a display substrate and the number of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in number but only to avoid the confusion of composition elements.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limits to the present disclosure. The positional relationships between the composition elements may be changed as appropriate according to the direction where each composition element is described. Therefore, appropriate replacements based on situations are allowed, not limited to the expressions in the specification.

In the specification, unless otherwise specified and defined, terms "mounting", "mutual connection", and "connection" should be generally understood. For example, the term may be fixed connection, or detachable connection, or integral connection. The term may be mechanical connection or electric connection. The term may be direct connection, or indirect connection through an intermediate, or communication inside two elements. Those of ordinary skills in the art can understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain electrode) and the source electrode (source electrode terminal, source region, or source electrode), and a current may flow through the drain electrode, the channel region, and the source region. It is to be noted that in the specification, the channel region refers to a main region that a current flows through.

In the specification, a first electrode may be the drain electrode, and a second electrode may be the source electrode. Alternatively, the first electrode may be a source electrode, and the second electrode may be a drain electrode. In cases that transistors with opposite polarities are used, or a current direction changes during work of a circuit, or the like, functions of the "source electrode" and the "drain electrode" may sometimes be exchanged. Therefore, the "source electrode" and the "drain electrode", as well as the "source terminal" and the "drain terminal", are interchangeable in the specification.

In the specification, "electric connection" includes connection of the composition elements through an element with a certain electric action. "An element with a certain electric action" is not particularly limited as long as electric signals between the connected composition elements may be sent and received. Examples of "an element with a certain electric action" not only include an electrode and a line, but also include a switch element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulating film" may be replaced with an "insulating layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In the present disclosure, "about" refers to that a boundary is not defined so strictly and numerical values within process and measurement error ranges are allowed.

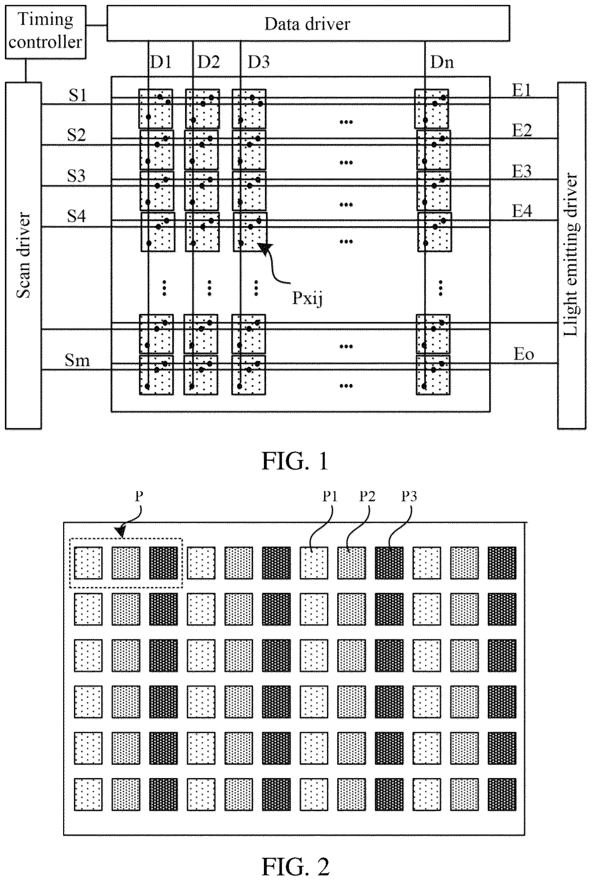

FIG. 1 is a schematic diagram of a structure of a display device. As shown in FIG. 1, the display device may include a timing controller, a data driver, a scan driver, a light emitting driver, and a pixel array. The timing controller is connected to the data driver, the scan driver, and the light emitting driver, respectively, the data driver is connected to a plurality of data signal lines (D1 to Dn) respectively, the scan driver is connected to a plurality of scan signal lines (S1 to Sm) respectively, and the light emitting driver is connected to a plurality of light emitting signal lines (E1 to Eo) respectively. The pixel array may include a plurality of sub-pixels Pxij, wherein i and j may be natural numbers. At least one sub-pixel Pxij may include a circuit unit and a light emitting device connected to the circuit unit, wherein the circuit unit may include a pixel drive circuit which is connected to a scan signal line, a data signal line, and a light emitting signal line, respectively. In an exemplary embodiment, the timing controller may provide a grayscale value and a control signal suitable for the specification of the data signal driver to the data signal driver, may provide a clock signal, a scan start signal, etc. suitable for the specification of the scan driver to the scan driver, and may provide a clock signal, an emission stop signal, etc. suitable for the specification of the light emitting driver to the light emitting driver. The data driver may generate data voltages to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a row of pixels as a unit, wherein n may be a natural number. The scan driver may generate a scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and generate a scan signal in a manner of sequentially transmitting a scan start signal provided in a form of an on-level pulse to a next-stage circuit under control of the clock signal, wherein m may be a natural number. The light emitting driver may receive a clock signal, an emission stop signal, etc., from the timing controller to generate an emission signal to be provided to the light emitting signal lines E1, E2, E3, ..., and Eo. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number.

FIG. 2 is a schematic diagram of a planar structure of a display substrate. In an exemplary embodiment, the display substrate may include a plurality of pixel units P arranged in a matrix, and at least one pixel unit P may include a first sub-pixel P1 emitting light of a first color, a second sub-pixel P2 emitting light of a second color, and a third sub-pixel P3 emitting light of a third color. The three sub-pixels may each include a circuit unit and a light emitting unit. The circuit unit may include a pixel drive circuit, and the light emitting unit may include a light emitting unit. The pixel drive circuit is respectively connected to a scan signal line, a data signal line and a light emitting signal line. The pixel drive circuit is configured to receive a data voltage transmitted by the data signal line and output a corresponding current to the light emitting device, under control of the scan signal line and the light emitting signal line. The light emitting unit is configured to emit light of a corresponding luminance in response to a current output by the pixel drive circuit connected thereto.

In an exemplary embodiment, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary embodiment, the sub-pixels may have a shape of a rectangle, a rhombus, a pentagon, or a hexagon. Three sub-pixels may be provided side by side horizontally, side by side vertically, or in a

品

manner like a Chinese character "　".

In another exemplary embodiment, the pixel unit P may include four sub-pixels, which may be arranged side by side horizontally, side by side vertically, or in a diamond shape or a square shape, which is not limited in the present disclosure.

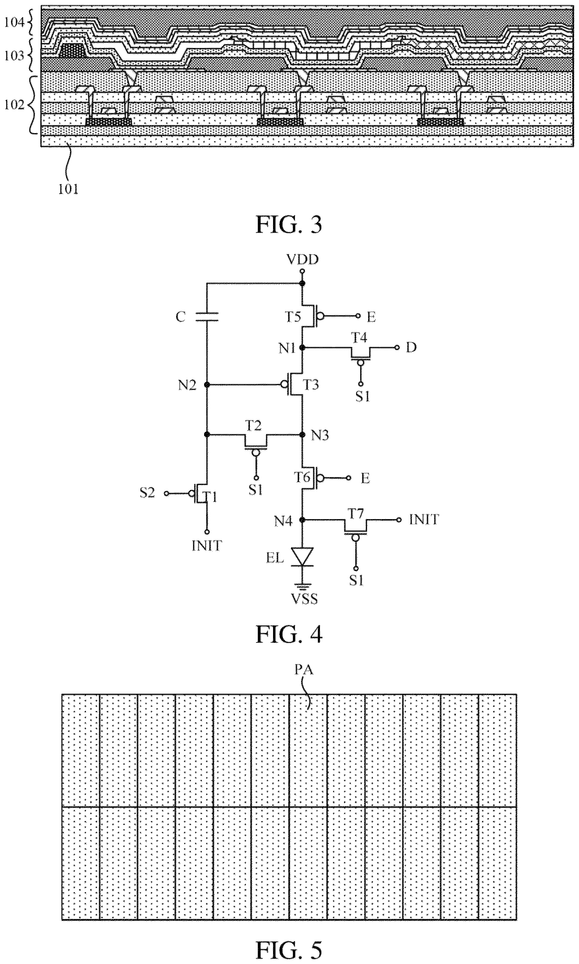

FIG. 3 is a schematic diagram of a sectional structure of a display substrate, and illustrates a structure of three sub-pixels of the display substrate. As shown in FIG. 3, on a plane perpendicular to the display substrate, the display substrate may include a drive circuit layer 102 provided on a base substrate 101, a light emitting structure layer 103 provided on a side of the drive circuit layer 102 away from the base substrate, and an encapsulation layer 104 provided on a side of the light emitting structure layer 103 away from the base substrate. In some possible implementations, the display substrate may include another film layer, such as a post spacer, which is not limited in the present disclosure.

In an exemplary embodiment, the base substrate 101 may be a flexible base substrate, or may be a rigid base substrate. The drive circuit layer 102 of each sub-pixel may include a plurality of circuit units, the circuit unit may include a pixel drive circuit composed of a plurality of transistors and a storage capacitor. FIG. 3 is only illustrated as an example in which the pixel drive circuit includes one drive transistor and one storage capacitor. The light emitting structure layer 103 of each sub-pixel may include a plurality of light emitting units, and the light emitting unit may include an anode, a pixel definition layer, an organic light emitting layer, and a cathode. The anode is connected to a drain of a drive transistor through a via, the organic light emitting layer is connected to the anode, the cathode is connected to the organic light emitting layer, and the organic light emitting layer emits light of a corresponding color under driving of the anode and the cathode. The encapsulation structure layer 104 may include a first encapsulation layer, a second encapsulation layer, and a third encapsulation layer that are stacked. The first encapsulation layer and the third encapsulation layer may be made of an inorganic material, and the second encapsulation layer may be made of an organic material. The second encapsulation layer is provided between the first encapsulation layer and the third encapsulation layer, which can ensure that external water vapor cannot enter the light emitting structure layer 103.

In an exemplary embodiment, the organic light emitting layer may include an Emitting Layer (EML) and any one or more of a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary embodiment, the hole injection layers, the electron injection layers, the hole transport layers, the electron transport layers, the hole block layers and the electron block layers of all light emitting units may be connected together to form a common layer. The emitting layers of adjacent light emitting units may be overlapped slightly, or may be isolated.

FIG. 4 is a schematic diagram of an equivalent circuit of a pixel drive circuit. In an exemplary embodiment, the pixel drive circuit may have a structure of 3T1C, 4T1C, 5T1C, 5T2C, 6T1C, 7T1C, or 8T1C. As shown in FIG. 4, the pixel drive circuit may include seven transistors (a first transistor T1 to a seventh transistor T7), one storage capacitor C. The pixel drive circuit is connected to seven signal lines (a data signal line D, a first scan signal line S1, a second scan signal line S2, a light emitting signal line E, an initial signal line INIT, a first power supply line VDD, and a second power supply line VSS) respectively.

In an exemplary embodiment, the pixel drive circuit may include a first node N1, a second node N2, a third node N3 and a fourth node N4. The first node N1 is connected to a first electrode of the third transistor T3, a second electrode of the fourth transistor T4 and a second electrode of the fifth transistor T5, respectively. The second node N2 is connected to a second electrode of the first transistor, a first electrode of the second transistor T2, a control electrode of the third transistor T3 and a second end of the storage capacitor C, respectively. The third node N3 is connected to a second electrode of the second transistor T2, a second electrode of the third transistor T3 and a first electrode of the sixth transistor T6, respectively. The fourth node N4 is connected to a second electrode of the sixth transistor T6 and a second electrode of the seventh transistor T7, respectively.

In an exemplary embodiment, a first end of the storage capacitor C is connected to the first power supply line VDD, and the second end of the storage capacitor C is connected to the second node N2, i.e., the second end of the storage capacitor C is connected to the control electrode of the third transistor T3.

The control electrode of the first transistor T1 is connected to the second scan signal line S2, the first electrode of the first transistor T1 is connected to the initial signal line INIT, and the second electrode of the first transistor is connected to the second node N2. When a scan signal with an on-level is applied to the second scan signal line S2, the first transistor T1 transmits an initialization voltage to the control electrode of the third transistor T3 so as to initialize a charge amount of the control electrode of the third transistor T3.

The control electrode of the second transistor T2 is connected to the first scan signal line S1, the first electrode of the second transistor T2 is connected to the second node N2, and the second electrode of the second transistor T2 is connected to the third node N3. When a scan signal with an on-level is applied to the first scan signal line S1, the second transistor T2 enables the control electrode of the third transistor T3 to be connected to the second electrode of the third transistor T3.

The control electrode of the third transistor T3 is connected to the second node N2, i.e., the control electrode of the third transistor T3 is connected to the second end of the storage capacitor C, the first electrode of the third transistor T3 is connected to the first node N1, and the second electrode of the third transistor T3 is connected to the third node N3. The third transistor T3 may be referred to as a drive transistor, and the third transistor T3 determines an amount of a drive current flowing between the first power supply line VDD and the second power supply line VSS according to a potential difference between the control electrode and the first electrode of the third transistor T3.

The control electrode of the fourth transistor T4 is connected to the first scan signal line S1, the first electrode of the fourth transistor T4 is connected to the data signal line D, and the second electrode of the fourth transistor T4 is connected to the first node N1. The fourth transistor T4, may be referred to as a switching transistor, a scanning transistor, etc., and the fourth transistor T4 enables a data voltage of the data signal line D to be input into the pixel drive circuit when a scan signal with an on-level is applied to the first scan signal line S1.

The control electrode of the fifth transistor T5 is connected to the light emitting signal line E, the first electrode of the fifth transistor T5 is connected to the first power supply line VDD, and the second electrode of the fifth transistor T5 is connected to the first node N1. The control electrode of the sixth transistor T6 is connected to the light emitting signal line E, the first electrode of the sixth transistor T6 is connected to the third node N3, and the second electrode of the sixth transistor T6 is connected to the first electrode of the light emitting device EL. The fifth transistor T5 and the sixth transistor T6 may be referred to as light emitting transistors. When a light emitting signal with an on-level is applied to the light emitting signal line E, the fifth transistor T5 and the sixth transistor T6 enable the light emitting device EL to emit light by forming a drive current path between the first power supply line VDD and the second power supply line VSS.

The control electrode of the seventh transistor T7 is connected to the first scan signal line S1, the first electrode of the seventh transistor T7 is connected to the initial signal line INIT, and the second electrode of the seventh transistor T7 is connected to the first electrode of the light emitting device EL. When a scan signal with an on-level is applied to the first scan signal line S1, the seventh transistor T7 transmits an initialization voltage to the first electrode of the light emitting device EL so as to initialize a charge amount accumulated in the first electrode of the light emitting device or release the charge amount accumulated in the first electrode of the light emitting device EL.

In an exemplary embodiment, the light emitting device EL may be an OLED including a first electrode (anode), an organic light emitting layer, and a second electrode (cathode), which are stacked, or may be a QLED including a first electrode (anode), a quantum dot light emitting layer, and a second electrode (cathode), which are stacked.

In an exemplary embodiment, a second electrode of the light emitting device is connected to a second power supply line VSS, the signal of which is a continuously supplied low-level signal, and the signal of the first power supply line VDD is a continuously supplied high-level signal.

In an exemplary embodiment, the first transistor T1 to the seventh transistor T7 may be P-type transistors, or may be N-type transistors. Use of a same type of transistors in a pixel drive circuit may simplify a process flow, reduce a process difficulty of a display panel, and improve a product yield. In some possible implementations, the first transistor T1 to the seventh transistor T7 may include a P-type transistor and an N-type transistor.

In an exemplary embodiment, for the first transistor T1 to the seventh transistor T7, low temperature poly silicon thin film transistors may be adopted, or oxide thin film transistors may be adopted, or both a low temperature poly silicon thin film transistor and an oxide thin film transistor may be adopted. An active layer of a low temperature poly silicon thin film transistor may be made of Low Temperature Poly Silicon (LTPS for short), and an active layer of an oxide thin film transistor may be made of an oxide semiconductor (Oxide). The low temperature poly-silicon thin film transistors have advantages such as high migration rate and fast charging, and the oxide thin film transistors have advantages such as low leakage current. The low temperature poly-silicon thin film transistors and the oxide thin film transistors are integrated on one display substrate to form a low temperature polycrystalline oxide (LTPO) display substrate, so that the advantages of both the low temperature poly-silicon thin film transistors and the oxide thin film transistors can be utilized, low-frequency driving can be realized, power consumption can be decreased, and display quality can be improved.

In an exemplary embodiment, taking a case in which the seven transistors in the pixel drive circuit shown in FIG. 4 are all P-type OLED transistors as an example, the operation process of the pixel drive circuit may include the following stages A1-A3.

In a first stage A1, referred to as a reset stage, a signal of the second scan signal line S2 is a low-level signal, and signals of the first scan signal line S1 and the light emitting signal line E are high-level signals. The signal of the second scan signal line S2 is a low-level signal, so that the first transistor T1 is turned on, and a signal of the initial signal line INIT is provided to a second node N2 to initialize the storage capacitor C to clear an original data voltage in the storage capacitor. The signals of the first scan signal line S1 and the light emitting signal line E are high-level signals, so that the second transistor T2, the fourth transistor T4, the fifth transistor T5, the sixth transistor T6, and the seventh transistor T7 are turned off. An OLED does not emit light in this stage.

In a second stage A2, referred to as a data writing stage or a threshold compensation stage, a signal of the first scan signal line S1 is a low-level signal, signals of the second scan signal line S2 and the light emitting signal line E are high-level signals, and the data signal line D outputs a data voltage. In this stage, the second end of the storage capacitor C is at a low level, so the third transistor T3 is turned on. The signal of the first scan signal line S1 is the low-level signal, so that the second transistor T2, the fourth transistor T4, and the seventh transistor T7 are turned on. The second transistor T2 and the fourth transistor T4 are turned on, so that the data voltage output by the data signal line D is provided to the second node N2 through the first node N1, the turned-on third transistor T3, the third node N3, and the turned-on second transistor T2, and the storage capacitor C is charged with a difference between the data voltage output by the data signal line D and a threshold voltage of the third transistor T3. A voltage at the second end (the second node N2) of the storage capacitor C is Vd-|Vth|, wherein Vd is the data voltage output by the data signal line D, and Vth is the threshold voltage of the third transistor T3. The seventh transistor T7 is turned on, so that an initialization voltage of the initial signal line INIT is provided to a first electrode of the OLED to initialize (reset) the first electrode of the OLED and clear a pre-stored voltage therein, thereby completing initialization to ensure that the OLED does not emit light. A signal of the second scan signal line S2 is a high-level signal, so that the first transistor T1 is turned off. The signal of the light emitting signal line E is a high-level signal, so that the fifth transistor T5 and the sixth transistor T6 are turned off.

In a third stage A3, referred to as a light emitting stage, a signal of the light emitting signal line E is a low-level signal, and signals of the first scan signal line S1 and the second scan signal line S2 are high-level signals. The signal of the light emitting signal line E is a low-level signal, so that the fifth transistor T5 and the sixth transistor T6 are turned on, and a power voltage output by the first power supply line VDD provides a drive voltage to the first electrode of the OLED through the turned-on fifth transistor T5, third transistor T3, and sixth transistor T6 to drive the OLED to emit light.

In a driving process of the pixel drive circuit, a drive current flowing through the third transistor T3 (drive transistor) is determined by a voltage difference between a gate electrode and a first electrode of the third transistor T3. Since the voltage of the second node N2 is Vd-IVthI, the drive current of the third transistor T3 is as follows:

$$I = K*(Vgs-Vth)^2 = K*[(Vdd-Vd+|Vth|)-Vth]^2 = K*[(Vdd-Vd]^2$$

Herein, I is the drive current flowing through the third transistor T3, i.e., a drive current for driving the OLED, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

An exemplary embodiment of the present disclosure provides a display substrate. On a plane perpendicular to the display substrate, the display area may include a drive circuit layer provided on the base substrate, a light emitting structure layer provided on a side of the drive circuit layer away from the base substrate, and an encapsulation structure layer provided on a side of the light emitting structure layer away from the base substrate. On a plane parallel to the display substrate, the drive circuit layer may include a plurality of circuit units, and the circuit unit may at least include a pixel drive circuit configured to output a corresponding current under control of a corresponding signal line. The light emitting structure layer may include a plurality of light emitting units. The light emitting unit is connected to a pixel drive circuit of the corresponding circuit unit, and is configured to emit light of a corresponding luminance in response to a current output by the pixel drive circuit connected thereto.

In an exemplary embodiment, the circuit units mentioned in the present disclosure refer to regions divided according to pixel drive circuits, and light emitting units mentioned in the present disclosure refer to regions divided according to light emitting devices. In an exemplary embodiment, a position and shape of an orthographic projection of a light emitting unit on the base substrate may correspond to a position and shape of an orthographic projection of a circuit unit on the base substrate, or the position and shape of the orthographic projection of the light emitting unit on the base substrate may not correspond to the position and shape of the orthographic projection of the circuit unit on the base substrate.

FIG. 5 is a schematic diagram of an arrangement of circuit units according to an exemplary embodiment of the present disclosure. As shown in FIG. 5, in an exemplary embodiment, on a plane parallel to the display substrate, a drive circuit layer of the display area may include a plurality of circuit units PA, and the plurality of circuit units PA may constitute a plurality of unit rows and a plurality of unit columns. The unit row may include a plurality of circuit units PA sequentially provided in a first direction X, the unit column may include a plurality of circuit units PA sequentially provided in a second direction Y, and the first direction X intersects the second direction Y.

In an exemplary embodiment, the circuit unit PA may have a rectangular shape, long sides of the rectangular circuit unit PA may extend in the second direction Y (column direction), and short sides of the rectangular circuit unit PA may extend in the first direction X (row direction), thereby forming a horizontal parallel unit arrangement.

In an exemplary embodiment, the circuit unit PA may at least include a pixel drive circuit. The pixel drive circuit is connected to a scan signal line, a data signal line, and a light emitting signal line, respectively, and configured to receive a data voltage transmitted by the data signal line and output a corresponding current to the connected light emitting unit under control of the scan signal line and the light emitting signal line.

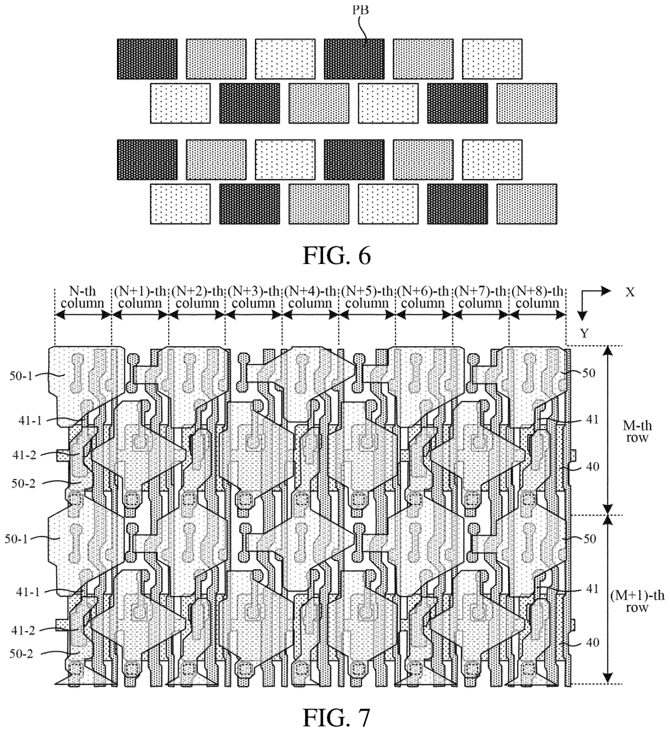

FIG. 6 is a schematic diagram of an arrangement of light emitting units according to an exemplary embodiment of the present disclosure. As shown in FIG. 6, in an exemplary embodiment, on a plane parallel to the display substrate, the light emitting structure layer of the display substrate may include a plurality of light emitting units PB arranged regularly, the plurality of light emitting units PB may constitute a plurality of pixel rows and a plurality of pixel columns. The pixel row may include a plurality of light emitting units PB sequentially provided in the first direction X, and the pixel column may include a plurality of light emitting units PB sequentially provided in the second direction Y.

In an exemplary embodiment, the plurality of light emitting units PB may include a red light emitting unit emitting red light, a blue light emitting unit emitting blue light, and a green light emitting unit emitting green light. The red light emitting units, the blue light emitting units, and the green light emitting units in each pixel row may be arranged periodically in the first direction X. The red light emitting units, the blue light emitting units, and the green light emitting units of the odd-numbered pixel rows and the even-numbered pixel rows are provided in a staggered manner. The six light emitting units share a nearby light emitting unit, thereby forming a Delta pixel arrangement that has a characteristic of a large pixel aperture ratio.

In an exemplary embodiment, the light emitting unit is connected to a pixel drive circuit of the corresponding circuit unit, and is configured to emit light of a corresponding luminance in response to a current output by the pixel drive circuit connected thereto.

In an exemplary embodiment, a shape of the light emitting unit PB may include any one or more of the following: a triangle, a rectangle, a diamond, a pentagon, and a hexagon.

An exemplary embodiment of the present disclosure provides a display substrate including a drive circuit layer provided on a base substrate, and a light emitting structure layer provided on a side of the drive circuit layer away from the base substrate. The drive circuit layer includes a plurality of circuit units, the circuit unit at least includes a pixel drive circuit, the pixel drive circuit at least includes a storage capacitor and a compensation transistor, a first electrode of the compensation transistor is connected to a first electrode plate of the storage capacitor through a first connection electrode; the light emitting structure layer includes a plurality of light emitting units, the light emitting unit at least includes an anode, and the anode is connected to the pixel drive circuit; an orthographic projection of the anode of at least one light emitting unit on the base substrate at least partially overlaps an orthographic projection of the first connection electrode of at least one circuit unit on the base substrate, and first connection electrodes of at least two circuit units have different shapes.

In an exemplary embodiment, the first connection electrode includes an electrode body portion and an electrode compensation portion, the electrode body portion includes a first end connected to the first electrode plate of the storage capacitor, and a second end connected to the first electrode of the compensation transistor, the electrode compensation portion is provided on a side of the first end away from the second end; electrode body portions of at least two circuit units have a same shape, and electrode compensation portions of at least two circuit units have different shapes.

In an exemplary embodiment, a plurality of circuit units form a plurality of unit rows and a plurality of unit columns, the unit row includes a plurality of circuit units sequentially provided in a first direction, the unit column includes a plurality of circuit units sequentially provided in a second direction, the first direction intersects the second direction; and in at least one unit column, first connection electrodes of at least two circuit units have a same shape.

In an exemplary embodiment, in at least one unit row, the plurality of circuit units at least include a first circuit unit, a second circuit unit and a third circuit unit. The pixel drive circuit of the first circuit unit is connected to a red light emitting unit emitting red light, the pixel drive circuit of the second circuit unit is connected to a blue light emitting unit emitting blue light, and the pixel drive circuit of the third circuit unit is connected to a green light emitting unit emitting green light. First connection electrodes in the first circuit unit, the second circuit unit, and the third circuit unit have different shapes.

In an exemplary embodiment, the anode of at least one light emitting unit includes an anode body portion, an anode connection portion and an anode compensation portion, the anode connection portion is configured to be connected to the pixel drive circuit, and the anode compensation portion is provided on a side of the anode connection portion away from the anode body portion.

In an exemplary embodiment, in at least one circuit unit, an orthographic projection of the anode compensation portion on the base substrate at least partially overlaps an orthographic projection of the electrode compensation portion of the first connection electrode on the base substrate.

In an exemplary embodiment, in at least one circuit unit, an orthographic projection of the anode compensation portion on the base substrate at least partially overlaps an orthographic projection of the electrode body portion of the first connection electrode on the base substrate.

In an exemplary embodiment, in at least one circuit unit, the anode is provided with a compensation notch configured to reduce an overlapping area of the anode and the first connection electrode.

In an exemplary embodiment, in a plane perpendicular to the display substrate, the drive circuit layer includes a semiconductor layer, a first conductive layer, a second conductive layer and a third conductive layer that are sequentially provided on the base substrate; the semiconductor layer at least includes an active layer of the compensation transistor, the first conductive layer at least includes the first electrode plate of the storage capacitor and a gate electrode of the compensation transistor, and the second conductive layer at least includes the second electrode plate of the storage capacitor, and the third conductive layer at least includes the first connection electrode.

FIG. 7 is a schematic diagram of a structure of a display substrate according to an exemplary embodiment of the present disclosure. In an exemplary embodiment, the display substrate may include a drive circuit layer provided on a base substrate, and a light emitting structure layer provided on a side of the drive circuit layer away from the base substrate. As shown in FIG. 7, on a plane parallel to the display substrate, the drive circuit layer may include a plurality of circuit units constituting a plurality of unit rows and a plurality of unit columns, the light emitting structure layer may include a plurality of light emitting units constituting a plurality of pixel rows and a plurality of pixel columns, at least one circuit unit may at least include a pixel drive circuit, and at least one light emitting unit may at least include an anode that is connected to a corresponding pixel drive circuit.

In an exemplary embodiment, the plurality of unit columns may include a first unit column and a second unit column, and the plurality of pixel columns may include a first pixel column and a second pixel column. In an exemplary embodiment, the first unit column and the first pixel column may be an odd-numbered unit column and an odd-numbered pixel column, respectively, and the second unit column and the second pixel column may be an even-numbered unit column and an even-numbered pixel column, respectively. In another exemplary embodiment, the first unit column and the first pixel column may be an even-numbered unit column and an even-numbered pixel column, respectively, and the second unit column and the second pixel column may be an odd-numbered unit column and an odd-numbered pixel column, respectively. In the following description of the present disclosure, illustration is made by taking an example in which the first unit column and the first pixel column are respectively the odd-numbered unit column and the odd-numbered pixel column, and the second unit column and the second pixel column are respectively the even-numbered unit column and the even-numbered pixel column, the odd-numbered unit columns and the odd-numbered pixel columns may include an N-th column, an (N+2)-th column, an (N+4)-th column, an (N+6)-th column, an (N+8)-th column, and the even-numbered unit columns and the even-numbered pixel columns may include an (N+1)-th column, an (N+3)-th column, an (N+5)-th column, and an (N+7)-th column.

In an exemplary embodiment, the pixel drive circuit of the circuit unit may at least include a compensation transistor and a storage capacitor 40, and a first electrode of the compensation transistor is connected to a first electrode plate of the storage capacitor 40 through a first connection electrode 41.

In an exemplary embodiment, an orthographic projection of the anode 50 of at least one light emitting unit in the first pixel column on the base substrate and an orthographic projection of the first connection electrode 41 of at least one circuit unit in the first unit column on the base substrate have a first overlapping area, an orthographic projection of the anode 50 of at least one light emitting unit in the second pixel column on the base substrate and an orthographic projection of the first connection electrode 41 of at least one circuit unit in the second unit column on the base substrate have a second overlapping area, and a ratio of the first overlapping area to the second overlapping area may be about 0.8 to 1.2.

In an exemplary embodiment, the first connection electrode 41 of at least one circuit unit in the first unit column may include an electrode body portion 41-1 and an electrode compensation portion 41-2, and the electrode compensation portion 41-2 may be provided on a side of the electrode body portion 41-1 in the second direction Y.

In an exemplary embodiment, the electrode body portion 41-1 may include a first end connected to the first electrode plate of the storage capacitor 40 and a second end connected to the first electrode of the compensation transistor, the electrode compensation portion 41-2 may be provided on a side of the first end of the electrode body portion 41-1 away from the second end, and the electrode compensation portion 41-2 extends in a direction away from the electrode body portion 41-1.

In an exemplary embodiment, the anode of at least one light emitting unit in the first pixel column may include an anode body portion 50-1 and an anode compensation portion 50-2, and the anode compensation portion 50-2 may be provided on a side of the anode body portion 50-1 in a direction opposite to the second direction Y.

In an exemplary embodiment, the anode 50 may further include an anode connection portion, the anode connection portion may be provided on a side of the anode body portion 50-1 in a direction opposite to the second direction Y, and is configured to be connected to the pixel drive circuit. The anode compensation portion 50-2 may be provided on a side of the anode connection portion away from the anode body portion 50-1. The anode compensation portion 50-2 extends in a direction away from the anode body portion 50-1.

In an exemplary embodiment, an orthographic projection of the anode compensation portion 50-2 on the base substrate at least partially overlaps an orthographic projection of the electrode compensation portion 41-2 of the first connection electrode 41 on the base substrate.

In an exemplary embodiment, an orthographic projection of the anode compensation portion 50-2 on the base substrate at least partially overlaps an orthographic projection of the electrode body portion 41-1 of the first connection electrode 41 on the base substrate.

In an exemplary embodiment, an orthographic projection of the anode body portion 50-1 of at least one light emitting unit in the first pixel column on the base substrate does not overlap an orthographic projection of the first connection electrode 41 on the base substrate, and an orthographic projection of the anode body portion 50-1 of at least one light emitting unit in the second pixel column on the base substrate at least partially overlaps an orthographic projection of the first connection electrode 41 on the base substrate.

In an exemplary embodiment, the first overlapping area may include an overlapping area of the orthographic projection of the anode compensation portion 50-2 on the base substrate and the orthographic projections of the electrode body portion 41-1 and the electrode compensation portion 41-2 on the base substrate, and the second overlapping area may include an overlapping area of the orthographic projection of the anode 50 on the base substrate and the orthographic projection of the first connection electrode 41 on the base substrate. The ratio of the first overlapping area to the second overlapping area may be about 0.9 to 1.1.

In an exemplary embodiment, on a plane perpendicular to the display substrate, the drive circuit layer may include a semiconductor layer, a first conductive layer, a second conductive layer, and a third conductive layer that are sequentially provided on the base substrate; the semiconductor layer at least includes active layers of a plurality of transistors in the pixel drive circuit, the first conductive layer at least includes a first electrode plate of the storage capacitor and gate electrodes of the plurality of transistors, the second conductive layer at least includes a second electrode plate of the storage capacitor, and the third conductive layer at least includes a first connection electrode 41.

In an exemplary embodiment, the drive circuit layer may include a first insulating layer, a second insulating layer, a third insulating layer, a fourth insulating layer, and a planarization layer. The first insulating layer is provided between the base substrate and the semiconductor layer, the second insulating layer is provided between the semiconductor layer and the first conductive layer, the third insulating layer is provided between the first conductive layer and the second conductive layer, the fourth insulating layer is provided between the second conductive layer and the third conductive layer, and the planarization layer is provided between the third conductive layer and the anode.

Exemplary description is made below through a manufacturing process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation and chemical vapor deposition, the coating may be any one or more of spray coating, spin coating and inkjet printing, and the etching may be any one or more of dry etching and wet etching, the present disclosure is not limited thereto. A "thin film" refers to a layer of thin film made of a certain material on a substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are provided in a same layer" in the present disclosure means that A and B are formed simultaneously through a same patterning process, and a "thickness" of a film layer is a size of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is coincided with the boundary of the orthographic projection of B.

In an exemplary embodiment, manufacturing of the display substrate may at least include manufacturing a drive circuit layer and manufacturing a light emitting structure layer.

In an exemplary embodiment, taking eighteen circuit units (2 unit rows and 9 unit columns) as an example, the manufacturing process of the drive circuit layer may include the following operations.

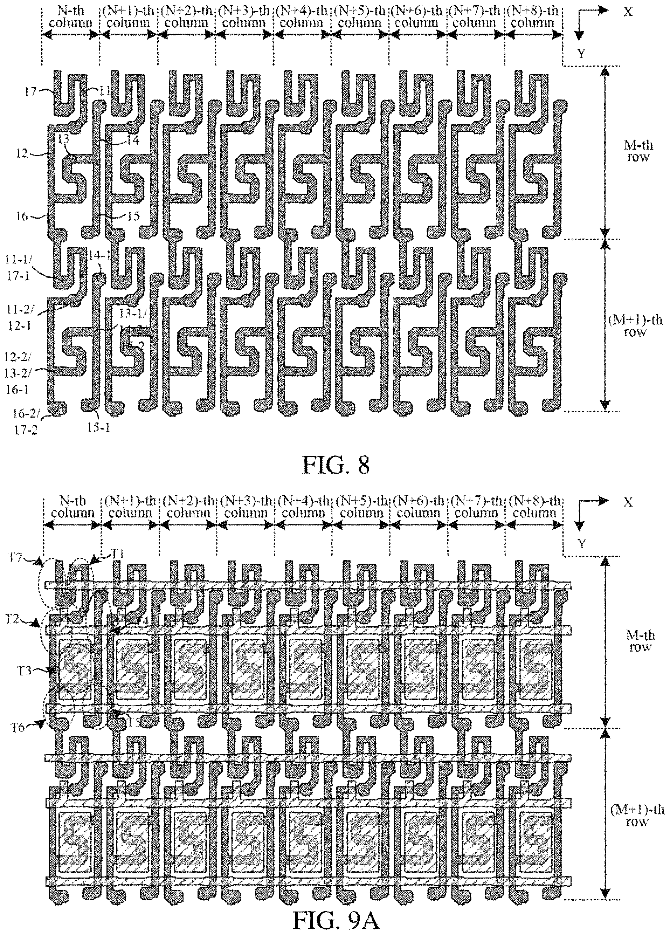

(1) A pattern of a semiconductor layer is formed. In an exemplary embodiment, forming the pattern of the semiconductor layer may include: sequentially depositing a first insulating thin film and a semiconductor thin film on a base substrate, and patterning the semiconductor thin film by a patterning process to form a first insulating layer covering the base substrate and the semiconductor layer provided on the first insulating layer, as shown in FIG. 8.

In an exemplary embodiment, the semiconductor layer of each circuit unit may at least include a first active layer 11 of a first transistor T1 to a seventh active layer 17 of a seventh transistor T7, and the first active layer 11 to the seventh active layer 17 are an interconnected integral structure. In each unit column, a sixth active layer 16 of the circuit unit at the M-th row and a seventh active layer 17 of the circuit unit at the (M+1)-th row are connected to each other, that is, the semiconductor layers of adjacent circuit units in each unit column are an interconnected integral structure.

In an exemplary embodiment, in the first direction X, the fourth active layer 14 and the fifth active layer 15 in the circuit unit at the N-th column may be located on a side of the third active layer 13 of the present circuit unit close to the circuit unit at the (N+1)-th column, and the second active layer 12 and the sixth active layer 16 may be located on a side of the third active layer 13 of the present circuit unit away from the circuit unit at the (N+1)-th column.

In an exemplary embodiment, in the second direction Y, the first active layer 11, the second active layer 12, the fourth active layer 14 and the seventh active layer 17 in the circuit unit at the M-th row may be located on a side of the third active layer 13 of the present circuit unit away from the circuit unit at the (M+1)-th row, the first active layer 11 and the seventh active layer 17 may be located on a side of the second active layer 12 and the fourth active layer 14 away from the third active layer 13, and the fifth active layer 15 and the sixth active layer 16 in the circuit unit at the M-th row may be located on a side of the third active layer 13 close to the circuit unit at the (M+1)-th row.

In an exemplary embodiment, the first active layer 11 may have an "n" shape, the third active layer 13 may have an "S" shape, the second active layer 12 may have an "L" shape, and the fourth active layer 14, the fifth active layer 15, the sixth active layer 16 and the seventh active layer 17 may have an "I" shape.

In an exemplary embodiment, an active layer of each transistor may include a first region, a second region, and a channel region located between the first region and the second region. In an exemplary embodiment, a first region 11-1 of the first active layer 11 may serve as a first region 17-1 of the seventh active layer 17; a second region 11-2 of the first active layer 11 may serve as a first region 12-1 of the second active layer 12; a first region 13-1 of the third active layer 13 may serve as a second region 14-2 of the fourth active layer 14 and a second region 15-2 of the fifth active layer 15 simultaneously; a second region 13-2 of the third active layer 13 may serve as a second region 12-2 of the second active layer 12 and a first region 16-1 of the sixth active layer 16 simultaneously; a second region 16-2 of the sixth active layer 16 may simultaneously serve as a second region 17-2 of the seventh active layer 17; and a first region 14-1 of the fourth active layer 14 and a first region 15-1 of the fifth active layer 15 may be separately provided.

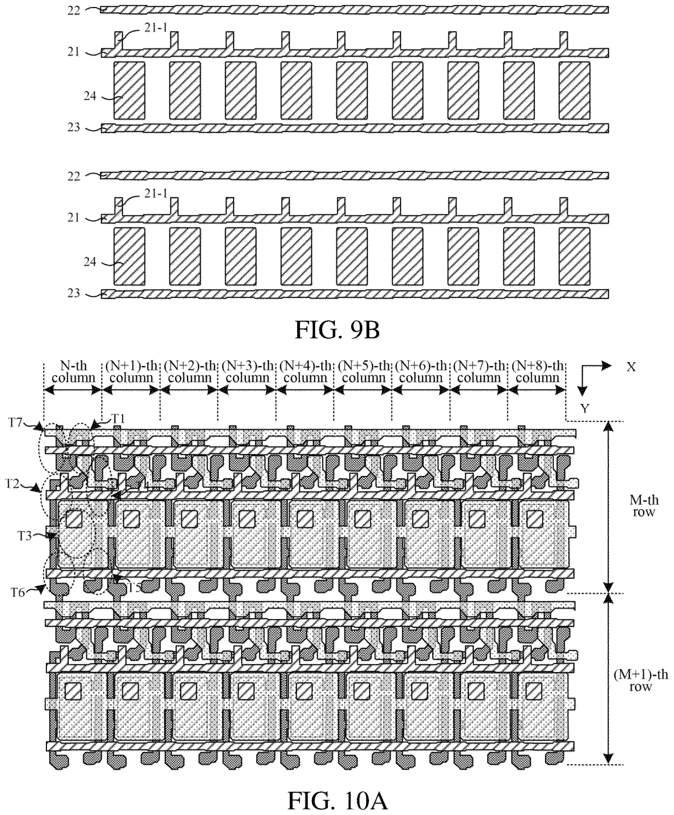

(2) A pattern of a first conductive layer is formed. In an exemplary embodiment, forming the pattern of the first conductive layer may include: sequentially depositing a second insulating thin film and a first conductive thin film on the base substrate on which the aforementioned pattern is formed, and patterning the first conductive thin film by a patterning process to form a second insulating layer covering the pattern of the semiconductor layer and form the pattern the a first conductive layer provided on the second insulating layer, as shown in FIGS. 9A and 9B, wherein FIG. 9B is a planar schematic diagram of the first conductive layer in FIG. 9A. In an exemplary embodiment, the first conductive layer may be called a first gate metal (GATE1) layer.

In an exemplary embodiment, the pattern of the first conductive layer of each circuit unit may at least include a first scan signal line 21, a second scan signal line 22, a light emitting control signal line 23 and a first electrode plate 24.

In an exemplary embodiment, the first electrode plate 24 of the storage capacitor may have a shape of a rectangle, corners of which may be provided as chamfers. An orthographic projection of the first electrode plate 24 on the base substrate at least partially overlaps an orthographic projection of the third active layer of the third transistor T3 on the base substrate. In an exemplary embodiment, the first electrode plate 24 may simultaneously serve as an electrode plate of the storage capacitor and a gate electrode of the third transistor T3.

In an exemplary embodiment, the first scan signal line 21, the second scan signal line 22, and the light emitting control signal line 23 may have line shapes in which main body portions thereof extend in the first direction X. The first scan signal line 21 in the circuit unit at the M-th row may be located on a side of the first electrode plate 24 of the present circuit unit away from the circuit unit at the (M+1)-th row, the second scan signal line 22 may be located on a side of the first scan signal line 21 away from the first electrode plate 24, and the light emitting control signal line 23 may be located on a side of the first electrode plate 24 of the present circuit unit close to the circuit unit at the (M+1)-th row.

In an exemplary embodiment, a side of the first scan signal line 21 away from the first electrode plate 24 is provided with a gate block 21-1, a region where the first scan signal line 21 and the gate block 21-1 overlap the second active layer 12 serves as a gate electrode of the second transistor T2 of a double-gate structure, and a region where the first scan signal line 21 overlaps the fourth active layer 14 serves as a gate electrode of the fourth transistor T4.

In an exemplary embodiment, a region where the second scan signal line 22 overlaps the first active layer 11 serves as a gate electrode of the first transistor T1 of a double-gate structure, a region where the second scan signal line 22 overlaps the seventh active layer 17 serves as a gate electrode of the seventh transistor T7, a region where the light emitting control signal line 23 overlaps the fifth active layer 15 serves as a gate electrode of the fifth transistor T5, and a region where the light emitting control signal line 23 overlaps the sixth active layer 16 serves as a gate electrode of the sixth transistor T6.

In an exemplary embodiment, after the pattern of the first conductive layer is formed, a conductive processing may be performed on the semiconductor layer by using the first conductive layer as a shield, the semiconductor layer in a region shielded by the first conductive layer forms channel regions of the first transistor T1 to the seventh transistor T7, and the semiconductor layer in a region not shielded by the first conductive layer is made to be conductive, that is, first regions and second regions of the first active layer to the seventh active layer are all made to be conductive.

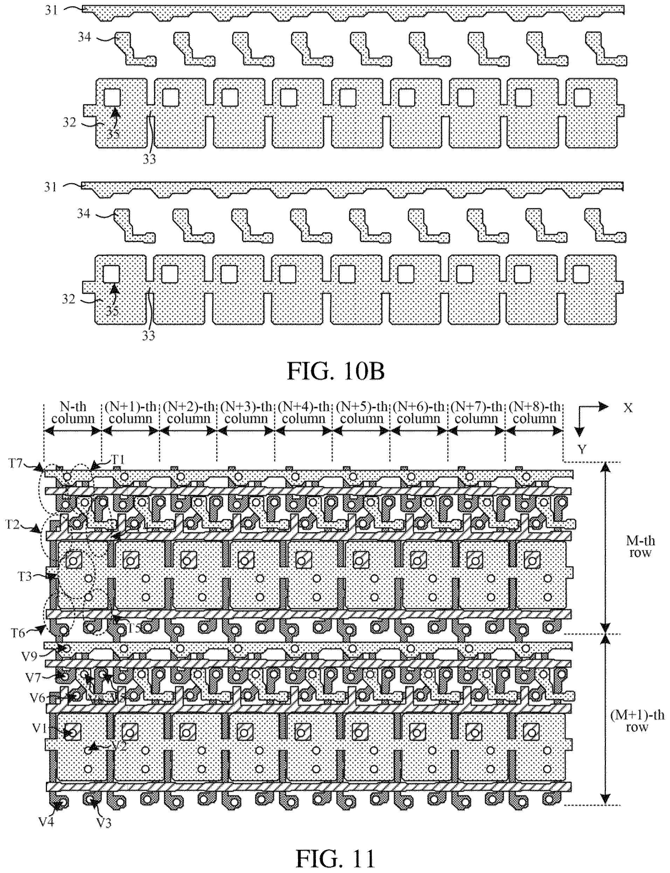

(3) A pattern of a second conductive layer is formed. In an exemplary embodiment, forming the pattern of the second conductive layer may include: sequentially depositing a third insulating thin film and a second conductive thin film on the base substrate on which the aforementioned patterns are formed, and patterning the second conductive thin film by a patterning process to form a third insulating layer covering the first conductive layer and form the pattern of the second conductive layer provided on the third insulating layer, as shown in FIGS 10A and 10B, wherein FIG. 10B is a planar schematic diagram of the second conductive layer in FIG. 10A. In an exemplary embodiment, the second conductive layer may be called a second gate metal (GATE 2) layer.

In an exemplary embodiment, the pattern of the second conductive layer of each circuit unit may at least include an initial signal line 31, a second electrode plate 32, an electrode connection line 33, and a shield electrode 34.

In an exemplary embodiment, the initial signal line 31 may have a line shape in which a main body portion of the initial signal line 31 extends in the first direction X. The initial signal line 31 in the circuit unit at the M-th row may be located on a side of the second scan signal line 22 away from the first scan signal line 21, and the initial signal line 31 is configured to provide an initial voltage signal to the first transistor T1 and the seventh transistor T7.

In an exemplary embodiment, an outline of the second electrode plate 32 may have a rectangular shape, corners of which may be provided as chamfers. An orthographic projection of the second electrode plate 32 on the base substrate at least partially overlaps an orthographic projection of the first electrode plate 24 on the base substrate, and the first electrode plate 24 and the second electrode plate 32 form the storage capacitor of the pixel drive circuit.

In an exemplary embodiment, the electrode plate connection line 33 may be provided on a side of the second electrode plate 32 in the first direction X or on a side of the second electrode plate 32 in a direction opposite to the first direction X. A first end of the electrode plate connection line 33 is connected to the second electrode plate 32 of the present circuit unit. A second end of the electrode plate connection line 33 is connected to the second electrode plate 32 of an adjacent circuit unit at the circuit row after extending in the first direction X or in a direction opposite to the first direction X, so that the second electrode plates 32 of the adjacent circuit units at a unit row are connected to each other through the electrode plate connection lines 33. In an exemplary embodiment, the second electrode plate 32 is connected to a first voltage line formed subsequently, second electrode plates of a plurality of circuit units at a unit row form an interconnected integral structure by the electrode plate connection line 33, the second electrode plates of the integral structure may be reused as a power supply signal line, so as to ensure that a plurality of second electrode plates at a unit row have a same potential, which is beneficial to improving uniformity of a panel, avoiding a display defect of the display substrate and ensuring a display effect of the display substrate.

In an exemplary embodiment, an opening 35 is provided on the second electrode plate 32 and may be located in a middle part of the second electrode plate 32, and the opening 35 may have a shape of a rectangle, so that the second electrode plate 32 forms an annular structure. The opening 35 exposes the third insulating layer covering the first electrode plate 24, and an orthographic projection of the first electrode plate 24 on the base substrate includes an orthographic projection of the opening 35 on the base substrate. In an exemplary embodiment, the opening 35 is configured to accommodate a first via formed subsequently, and the first via is located in the opening 35 and exposes the first electrode plate 24, so that a second electrode of the first transistor T1 formed subsequently is connected to the first electrode plate 24.

In an exemplary embodiment, the shield electrode 34 may be located between the first scan signal line 21 (excluding a main body portion of the gate block 21-1) and the second scan signal line 22 of the present circuit unit, and may have an "L" shape. An orthographic projection of the shield electrode 34 on the base substrate at least partially overlaps an orthographic projection of the second region of the first active layer on the base substrate, and the orthographic projection of the shield electrode 34 on the base substrate at least partially overlaps an orthographic projection of the first region of the second active layer on the base substrate. The shield electrode 34 is configured to shield an influence of the data voltage jump on the key node(s), preventing the data voltage jump from affecting the potential of the key node(s) of the pixel drive circuit, and thereby improving the display effect.

(4) A pattern of a fourth insulating layer is formed. In an exemplary embodiment, forming the pattern of the fourth insulating layer may include: depositing a fourth insulating thin film on the base substrate on which the aforementioned patterns are formed, and patterning the fourth insulating thin film by a patterning process, to form the fourth insulating layer covering the second conductive layer, wherein a plurality of vias are provided in each circuit unit, as shown in FIG. 11.

In an exemplary embodiment, the plurality of vias of each circuit unit may at least include a first via V1, a second via V2, a third via V3, a fourth via V4, a fifth via V5, a sixth via V6, a seventh via V7, an eighth via V8 and a ninth via V9.

In an exemplary embodiment, an orthographic projection of the first via V1 on the base substrate is located within a range of an orthographic projection of the opening 35 of the second electrode plate 32 on the base substrate, the fourth insulating layer and the third insulating layer within the first via V1 are etched away to expose a surface of the first electrode plate 24, and the first via V1 is configured such that the second electrode of the first transistor T1 subsequently formed is connected to the first electrode plate 24 through the via.

In an exemplary embodiment, an orthographic projection of the second via V2 on the base substrate is within a range of an orthographic projection of the second electrode plate 32 on the base substrate, the fourth insulating layer in the second via V2 is etched away to expose a surface of the second electrode plate 32, and the second via V2 is configured such that the first power supply line formed subsequently is connected to the second electrode plate 32 through the via V2. In an exemplary embodiment, a quantity of second vias V2 may be multiple, and the multiple second vias V2 may be sequentially arranged in the second direction Y, thereby increasing the connection reliability between the first power supply line and the second electrode plate 32.

In an exemplary embodiment, an orthographic projection of the third via V3 on the base substrate is within a range of an orthographic projection of the first region of the fifth active layer on the base substrate. The fourth insulating layer, the third insulating layer and the second insulating layer in the third via V3 are etched away to expose a surface of the first region of the fifth active layer, and the third via V3 is configured such that the first power supply line formed subsequently is connected to the first region of the fifth active layer through the via V3.

In an exemplary embodiment, an orthographic projection of the fourth via V4 on the base substrate is within a range of an orthographic projection of the second region of the sixth active layer (also the second region of the seventh active layer) on the base substrate. The fourth insulating layer, the third insulating layer and the second insulating layer in the fourth via V4 are etched away to expose a surface of the second region of the sixth active layer, the fourth via V4 is configured such that the second electrode of the sixth transistor T6 (also the second electrode of the seventh transistor T7) formed subsequently is connected to the second region of the sixth active layer (also the second region of the seventh active layer) through the via V4.

In an exemplary embodiment, an orthographic projection of the fifth via V5 on the base substrate is within a range of an orthographic projection of the first region of the fourth active layer on the base substrate. The fourth insulating layer, the third insulating layer and the second insulating layer in the fifth via V5 are etched away to expose a surface of the first region of the fourth active layer, and the fifth via V5 is configured such that the data signal line formed subsequently is connected to the first region of the fourth active layer through the via V5.

In an exemplary embodiment, an orthographic projection of the sixth via V6 on the base substrate is within a range of an orthographic projection of the second region of the first active layer (also the first region of the second active layer) on the base substrate. The fourth insulating layer, the third insulating layer and the second insulating layer in the sixth via V6 are etched away to expose a surface of the second region of the first active layer, the sixth via V6 is configured such that the second electrode of the first transistor T1 formed subsequently (also the first electrode of the second transistor T2) is connected to the second region of the first active layer (also the first region of the second active layer) through the via V6.

In an exemplary embodiment, an orthographic projection of the seventh via V7 on the base substrate is within a range of an orthographic projection of the first region of the first active layer (also the first region of the seventh active layer) on the base substrate. The fourth insulating layer, the third insulating layer and the second insulating layer in the seventh via V7 are etched away to expose a surface of the first region of the first active layer, the seventh via V7 is configured such that the first electrode of the first transistor T1 formed subsequently (also the first electrode of the seventh transistor T7) is connected to the first region of the first active layer (also the first region of the seventh active layer) through the via V7.

In an exemplary embodiment, an orthographic projection of the eighth via V8 on the base substrate is within a range of an orthographic projection of the shield electrode 34 on the base substrate, the fourth insulating layer in the eighth via V8 is etched away to expose a surface of the shield electrode 34, and the eighth via V8 is configured such that the first power supply line subsequently formed is connected to the shield electrode 34 through the via.

In an exemplary embodiment, an orthographic projection of the ninth via V9 on the base substrate is within a range of an orthographic projection of the initial signal line 31 on the base substrate, the fourth insulating layer in the ninth via V9 is etched away to expose a surface of the initial signal line 31, and the ninth via V9 is configured such that the first electrode of the first transistor T1 formed subsequently (also the first electrode of the second transistor T7) is connected to the initial signal line 31 through the via V9.

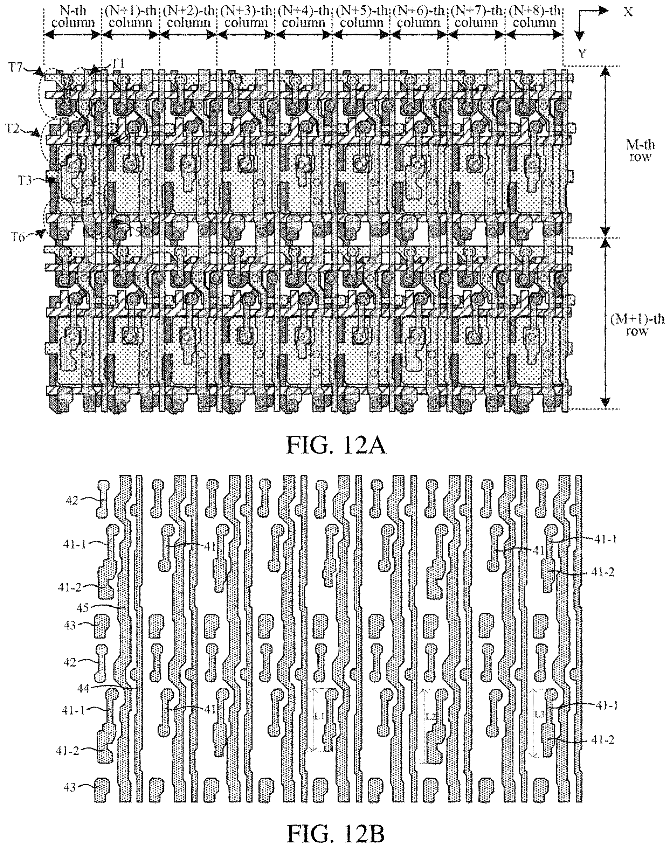

(5) A pattern of a third conductive layer is formed. In an exemplary embodiment, forming the third conductive layer may include: depositing a third conductive thin film on the base substrate on which the aforementioned patterns are formed, and patterning the third conductive thin film by a patterning process, to form a third conductive layer provided on the fourth insulating layer, as shown in FIGS. 12A and 12B, wherein FIG. 12B is a planar schematic diagram of the third conductive layer in FIG. 12A. In an exemplary embodiment, the third conductive layer may be called a first source-drain metal (SD1) layer.

In an exemplary embodiment, the third conductive layer of each circuit unit at least includes a first connection electrode 41, a second connection electrode 42, a third connection electrode 43, a data signal line 44 and a first power supply line 45.

In an exemplary embodiment, the first connection electrode 41 may have a strip shape extending in the second direction Y. The first connection electrode 41 is connected to the first electrode plate 24 and the second region of the first active layer (also the first region of the second active layer) through the first via V1 and the sixth via V6 respectively, so that the first electrode plate 24, the second electrode of the first transistor T1 and the first electrode of the second transistor T2 have a same potential. In an exemplary embodiment, the first connection electrode 41 may simultaneously serve as the second electrode of the first transistor T1 and the first electrode of the second transistor T2 (the second node N2 of the pixel drive circuit).

In an exemplary embodiment, the second connection electrode 42 may have a strip shape extending in the second direction Y. A first end of the second connection electrode 42 is connected to the first region of the first active layer (also the first region of the seventh active layer) through the seventh via V7, and a second end of the second connection electrode 42 is connected to the initial signal line 31 through the ninth via V9, so that the initial signal line 31 writes an initial voltage signal into the first transistor T1 and the seventh transistor T7. In an exemplary embodiment, the second connection electrode 42 may simultaneously serve as the first electrode of the first transistor T1 and the first electrode of the seventh transistor T7.

In an exemplary embodiment, the third connection electrode 43 may have a polygonal shape, and is connected to the second region of the sixth active layer (also the second region of the seventh active layer) through the fourth via V4, so that the second electrode of the sixth transistor T6 and the second electrode of the seventh transistor T7 have a same potential. In an exemplary embodiment, the third connection electrode 43 may serve as the second electrode of the sixth transistor T6 and the second electrode of the seventh transistor T7 simultaneously, and the third connection electrode 43 serves as an anode connection electrode, and is configured to be connected to an anode formed subsequently.

In an exemplary embodiment, the data signal line 44 may have a line shape in which a main body portion of the data signal line 44 extends in the second direction Y. The data signal line 44 is connected to a first region of the fourth active layer through the fifth via V5, thereby achieving that the data signal line 44 writes a data signal into the fourth transistor T4.

In an exemplary embodiment, the first power supply line 45 may have a polyline shape in which a main body portion of the first power supply line 45 extends in the second direction Y. On one aspect, the first power supply line 45 is connected to the second electrode plate 32 through the second via V2, on another aspect, the first power supply line 45 is connected to the first region of the fifth active layer through the third via V3, and on still another aspect, the first power supply line 45 is connected to the shield electrode 34 through the eighth via V8, thereby achieving that the first power supply line 45 writes the first power supply signal into the fifth transistor T5, and the second electrode plate 32 and the shield electrode 34 have a same potential as the first power supply line 45.

In an exemplary embodiment, since an orthographic projection of a strip portion of the shielding electrode 34 on the base substrate at least partially overlaps an orthographic projection of the first region of the second active layer on the base substrate, and the strip portion of the shielding electrode 34 extending in the second direction Y is located between the first connection electrode 41 and the data signal line 44, by connecting the shielding electrode 34 to the first power supply line 45, the shielding electrode 34 is a constant voltage signal, and may effectively shield an influence of the data voltage jump of the data signal line 44 on the second node N2 in the pixel drive circuit, and avoid an influence of the data voltage jump on the potential of the key node of the pixel drive circuit, thereby improving the display effect.

In an exemplary embodiment, the first connection electrode 41 and the data signal line 44 are respectively located on two sides of the first power supply line 45 in the first direction X. Since the first power supply line 45 is a constant voltage signal, it can effectively shield an influence of the data voltage jump on the second node N2 in the pixel drive circuit, and avoid an influence of the data voltage jump on the potential of the key node of the pixel drive circuit, thereby improving the display effect.

In an exemplary embodiment, the first power supply line 45 of at least one circuit unit may be a polyline of non-equal width. The first power supply line 45 is provided as a polyline, which can not only facilitate a layout of the pixel structures, but also reduce parasitic capacitance between the first power supply line and the data signal line.

In an exemplary embodiment, a shape of the first connection electrode 41 of at least one circuit unit in the first unit column may be different from a shape of the first connection electrode 41 of at least one circuit unit in the second unit column.

In an exemplary embodiment, in the plurality of first unit columns, a shape of the first connection electrode 41 of the circuit unit in at least one first unit column may be different from a shape of the first connection electrode 41 of the circuit unit in at least another first unit column.

In an exemplary embodiment, the first connection electrode 41 in at least one circuit unit may include an electrode body portion 41-1 and an electrode compensation portion 41-2. The electrode compensation portion 41-2 is configured to compensate a parasitic capacitance between the second node N2 and the fourth node N4 in the pixel drive circuit to eliminate a difference between a parasitic capacitance of the pixel drive circuit in an odd-numbered unit column and a parasitic capacitance of the pixel drive circuit in an even-numbered unit column.

In an exemplary embodiment, in at least one circuit unit, the electrode body portion 41-1 may include a first end connected to the first electrode plate of the storage capacitor and a second end connected to the first electrode of the compensation transistor, and the electrode compensation portion 41-2 may be provided on a side of the first end away from the second end, that is, the electrode compensation portion 41-2 may be provided on a side of the electrode body portion 41-1 in the second direction Y.

In an exemplary embodiment, a shape of the electrode body portion 41-1 of at least one circuit unit in the first unit column may be the same as a shape of the electrode body portion 41-1 of at least one circuit unit in the second unit column, and a shape of the electrode compensation portion 41-1 of at least one circuit unit in the first unit column may be different from a shape of the electrode compensation portion 41-1 of at least one circuit unit in the second unit column.

In an exemplary embodiment, in at least one unit column, first connection electrodes 41 of at least two circuit units may have a same shape.

In an exemplary embodiment, in at least one unit row, the plurality of circuit units may at least include a first circuit unit, a second circuit unit, and a third circuit unit. The pixel drive circuit of the first circuit unit is connected to a red light emitting unit emitting red light, the pixel drive circuit of the second circuit unit is connected to the blue light emitting unit emitting blue light, and the pixel drive circuit of the third circuit unit is connected to the green light emitting unit emitting green light. The first connection electrode 41 in the first circuit unit, the first connection electrode 41 in the second circuit unit, and the first connection electrode 41 in the third circuit unit may have different shapes.

In an exemplary embodiment, the electrode body portion 41-1 in the first circuit unit, the electrode body portion 41-1 in the second circuit unit, and the electrode body portion 41-1 in the third circuit unit may have a same shape, and the electrode compensation portion 41-2 in the first circuit unit, the electrode compensation portion 41-2 in the second circuit unit, and the electrode compensation portion 41-2 in the third circuit unit may have different shapes.

In an exemplary embodiment, the first connection electrode 41 of the first circuit unit has a first length L1, the first connection electrode 41 of the second circuit unit has a second length L2, and the first connection electrode 41 of the third circuit unit has a third length L3. the first length L1, the second length L2 and the third length L3 are different, and the first length L1, the second length L2 and the third length L3 are dimensions of the first connection electrodes 41 in the second direction Y.

In an exemplary embodiment, the second length L2 may be greater than the first length L1, and the second length L2 may be greater than the third length L3.

In an exemplary embodiment, the third length L3 may be greater than the first length L1.

In an exemplary embodiment, the first connection electrode 41 of the circuit unit in the first unit column may include an electrode body portion and an electrode compensation portion, while the first connection electrode 41 of the circuit unit in the second unit column may include only the electrode body portion, and the first connection electrodes 41 having the electrode compensation portion 41-2 may be provided in the circuit units of the interleaved unit columns.

In an exemplary embodiment, the electrode compensation portion 41-2 may have a strip shape extending in the second direction Y, the first end of the electrode compensation portion 41-2 is connected to the electrode body portion 41-1, and the second end of the electrode compensation portion 41-2 may extend in a direction away from the electrode body portion 41-1 in the second direction Y. Since the first connection electrode 41 has a potential of the second node N2 in the pixel drive circuit, the electrode compensation portion 41-2 has the potential of the second node N2 in the pixel drive circuit, and the electrode compensation portion 41-2 is configured to increase an overlapping area of the second node N2 in the first pixel column and the anode (the fourth node N4) formed subsequently, thereby increasing a parasitic capacitance between the second node N2 and the fourth node N4, such that a parasitic capacitance of the odd-numbered column is substantially the same as that of the even-numbered column.

In an exemplary embodiment, since the electrode compensation portion 41-2 is configured to adjust an overlapping area of the first connection electrode and the anode, and the anodes in different pixel columns may have different positions and shapes, some first unit columns may be provided with the electrode compensation portions 41-2, while some first unit columns may not be provided with the electrode compensation portion 41-2. The electrode compensation portions 41-2 provided in some circuit units may have the same position and shape, and the electrode compensation portions 41-2 provided in some other circuit units may have different positions and shapes, which is not limited in the present disclosure.

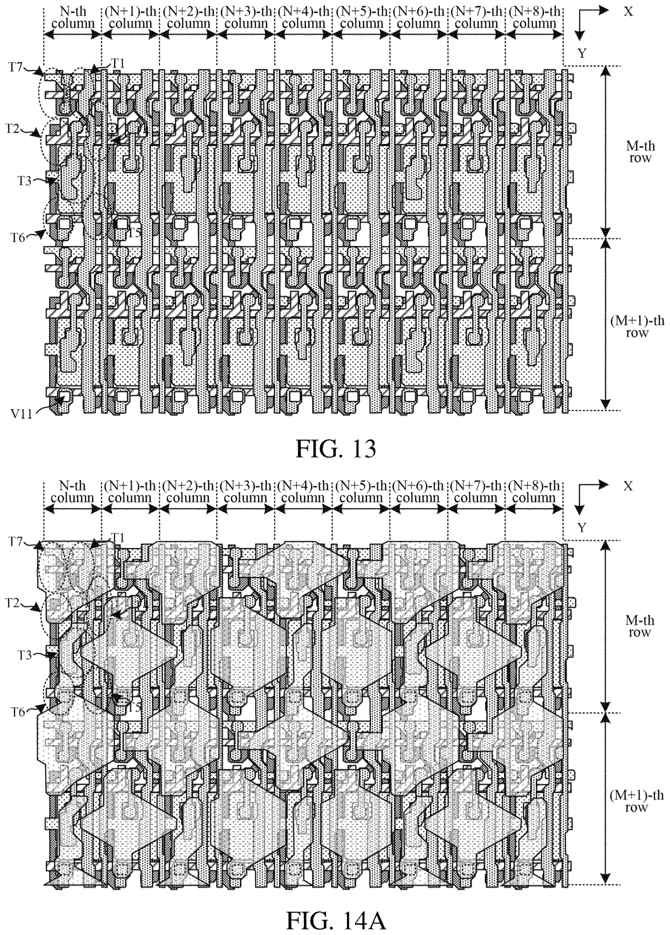

(6) A pattern of a planarization layer is formed. In an exemplary embodiment, forming the pattern of the planarization layer may include: coating a planarization film on the base substrate on which the above-mentioned patterns are formed, patterning the planarization thin film by a patterning process, to form the planarization layer covering the third conductive layer, wherein the planarization layer is provided with a plurality of vias, as shown in FIG. 13.

In an exemplary embodiment, the via in each circuit unit at least includes an eleventh via V11. An orthographic projection of the eleventh via V11 on the base substrate is located within a range of an orthographic projection of the third connection electrode 43 on the base substrate, the planarization layer in the eleventh via V11 is removed to expose a surface of the third connection electrode 43, and the eleventh via V11 is configured such that the anode formed subsequently is connected to the third connection electrode 43 through this via.

So far, the drive circuit layer has been manufactured on the base substrate. On a plane parallel to the display substrate, the drive circuit layer may include multiple circuit units, each of the circuit units may include a pixel drive circuit, and a first scan signal line, a second scan signal line, a light emitting control signal line, an initial signal line, a data signal line, and a first power supply line connected to the pixel drive circuit. On a plane perpendicular to the display substrate, the drive circuit layer may include a first insulating layer, a semiconductor layer, a second insulating layer, a first conductive layer, a third insulating layer, a second conductive layer, a fourth insulating layer, a third conductive layer, and a planarization layer which are stacked sequentially on the base substrate.

In an exemplary embodiment, the base substrate may be a flexible base substrate, or a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In an exemplary embodiment, the flexible base substrate may include a first flexible material layer, a first inorganic material layer, a semiconductor layer, a second flexible material layer, and a second inorganic material layer which are stacked, wherein a material of the first flexible material layer and the second flexible material layer may be Polyimide (PI), Polyethylene Terephthalate (PET), or a surface-treated polymer soft film, or the like, a material of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary embodiment, the first conductive layer, the second conductive layer, and the third conductive layer may be made of a metal material, for example, any one or more of Argentum (Ag), Copper (Cu), Aluminum (Al), and Molybdenum (Mo), or an alloy material of the above-mentioned metals, for example, an Aluminum-Neodymium alloy (AlNd) or a Molybdenum-Niobium alloy (MoNb), and may be in a single-layer structure, or in a multilayer composite structure such as Mo/Cu/Mo, etc. The first insulating layer, the second insulating layer, the third insulating layer, and the fourth insulating layer may be made of any one or more of Silicon Oxide (SiOx), Silicon Nitride (SiNx), and Silicon Oxynitride (SiON), and may be a single layer, a multi-layer, or a composite layer. The first insulating layer may be referred to as a buffer layer, the second insulating layer and the third insulating layer may be referred to as Gate Insulator (GI) layers, and the fourth insulating layer may be referred to as an Interlayer Dielectric (ILD) layer. The planarization layer may be made of an organic material such as resin. An active layer may be made of a material such as amorphous Indium Gallium Zinc Oxide (a-IGZO), Zinc Oxynitride (ZnON), Indium Zinc Tin Oxide (IZTO), amorphous Silicon (a-Si), poly Silicon (p-Si), hexathiophene, or polythiophene. That is, the present disclosure is applicable to a transistor that is manufactured based on an oxide technology, a silicon technology, or an organic matter technology.

In an exemplary embodiment, after manufacturing of the drive circuit layer is completed, a light emitting structure layer is manufactured on the drive circuit layer, and a manufacturing process of the light emitting structure layer may include following operations.

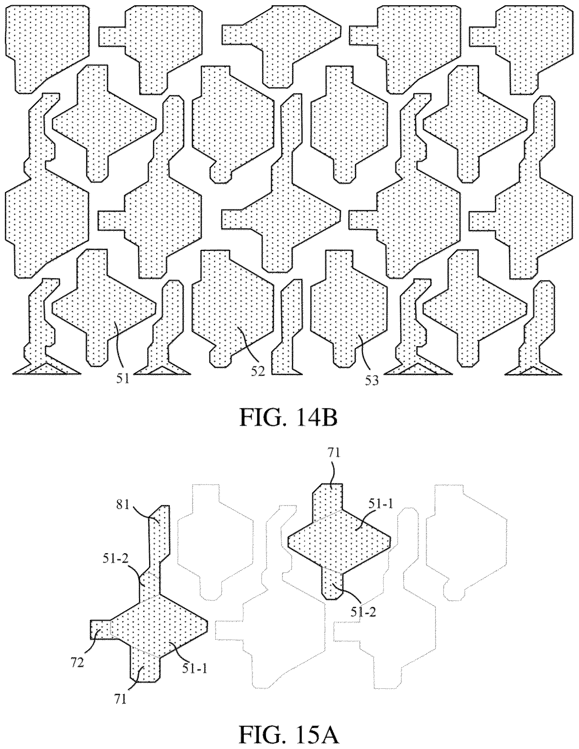

(9) A pattern of an anode conductive layer is formed. In an exemplary embodiment, forming the pattern of the anode conductive layer may include: depositing an anode conductive thin film on the base substrate on which the aforementioned patterns are formed, and patterning the anode conductive thin film by a patterning process to form the pattern of the anode conductive layer provided on the planarization layer, as shown in FIGS. 14A and 14B, wherein FIG. 14B is a planar schematic diagram of the anode conductive layer in FIG. 14A.

In an exemplary embodiment, the pattern of the anode conductive layer may at least include a plurality of anodes, and the plurality of anodes may include a first anode 51 of a red light emitting unit, a second anode 52 of a blue light emitting unit, and a third anode 53 of a green light emitting unit. A region where the first anode 51 is located may form a red light emitting unit that emits red light, a region where the second anode 52 is located may form a blue light emitting unit that emits blue light, and a region where the third anode 53 is located may form a green light emitting unit that emits green light.

In an exemplary embodiment, the first anode 51, the second anode 52, and the third anode 53 may be respectively connected to the third connection electrodes 43 in the corresponding circuit units through the eleventh vias V11. Since the third connection electrode 43 in the circuit unit is connected to the second region of the sixth active layer (also the second region of the seventh active layer) through a via, the first anode 51, the second anode 52 and the third anode 53 may be respectively connected to the second electrode of the sixth transistor t6 and the second electrode of the seventh transistor T7 through the third connection electrodes 43, thereby realizing that the pixel drive circuit drives the light emitting device to emit light.

In an exemplary embodiment, the plurality of light emitting units may constitute a plurality of pixel rows and a plurality of pixel columns. The pixel row may include a plurality of light emitting units sequentially provided in the first direction X, and the pixel column may include a plurality of light emitting units sequentially provided in the second direction Y.

In an exemplary embodiment, a plurality of light emitting units of two pixel rows correspond to positions of a plurality of pixel drive circuits of one unit row, that is, a region of one unit row corresponds to a region of two pixel rows. The first anodes 51, the second anodes 52, and the third anodes 53 in each pixel row may be periodically provided in the first direction X, and the first anodes 51, the second anodes 52, and the third anodes 53 of an adjacent pixel row are provided in a staggered manner.

In an exemplary embodiment, a plurality of light emitting units of one pixel column corresponds to positions of a plurality of pixel drive circuits of one unit column, that is, a region of one unit column corresponds to a region of one pixel column. Each pixel column includes a plurality of anodes sequentially provided in the second direction Y, and a plurality of anodes of an adjacent pixel column are provided in a staggered manner. The plurality of anodes of one pixel column may be a plurality of first anodes 51, the plurality of anodes of another pixel column may be a plurality of second anodes 52, and the plurality of anodes of still another pixel column may be a plurality of third anodes 53.

In an exemplary embodiment, in the first direction X, the first anode 51 at one pixel row may be located between a second anode 52 and a third anode 53 at an adjacent pixel row, the three anodes constitute a triangular-arranged pixel unit. In the first direction X, a second anode 52 at one pixel row may be located between a third anode 53 and a first anode 51 at an adjacent pixel row, and these three anodes constitute a triangular-arranged pixel unit. In the first direction X, a third anode 53 at one pixel row may be located between a first anode 51 and a second anode 52 at an adjacent pixel row, and these three anodes constitute a triangular-arranged pixel unit. Thus, the plurality of first anodes 51, the plurality of second anodes 52 and the plurality of third anodes 53 form a Delta pixel arrangement.

In an exemplary embodiment, in the second direction Y, the first anode 51 at one pixel column may be located between two second anodes 52 at an adjacent pixel column, the first anode 51 at one pixel column may be located between two third anodes 53 at another adjacent pixel column, and one first anode 51, two second anodes 52, and two third anodes 53 may constitute four triangular-arranged pixel units. In the second direction Y, the second anode 52 at one pixel column may be located between two first anodes 51 at an adjacent pixel column, the second anode 52 at one pixel column may be located between two third anodes 53 at another adjacent pixel column, and two first anodes 51, one second anode 52, and two third anodes 53 may constitute four triangular-arranged pixel units. In the second direction Y, the third anode 53 at one pixel column may be located between two second anodes 52 at an adjacent pixel column, the third anode 53 at one pixel column may be located between two first anodes 51 at another adjacent pixel column, and two first anodes 51, two second anodes 52, and one third anode 53 may constitute four triangular-arranged pixel units.

In an exemplary embodiment, the first anode 51, the second anode 52 and the third anode 53 may have different shapes and areas.

In an exemplary embodiment, the plurality of pixel rows may include a first pixel row and a second pixel row. The first anode 51 at the first pixel row and the first anode 51 at the second pixel row may have different shapes and areas, the second anode 52 at the first pixel row and the second anode 52 at the second pixel row may have different shapes and areas, and the third anode 53 at the first pixel row and the third anode 53 at the second pixel row may have different shapes and areas.

In an exemplary embodiment, the anode conductive layer may be of a single-layer structure, such as Indium Tin Oxide (ITO) or Indium Zinc Oxide (IZO), or may be of a multi-layer composite structure, such as ITO/Ag/ITO.

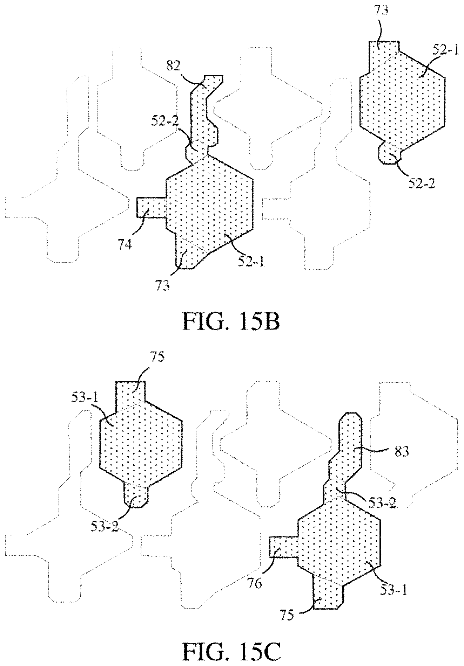

FIG. 15A is a planar schematic diagram of a first anode according to an exemplary embodiment of the present disclosure, FIG. 15B is a planar schematic diagram of a second anode according to an exemplary embodiment of the present disclosure, and FIG. 15C is a planar schematic diagram of a third anode according to an exemplary embodiment of the present disclosure. In an exemplary embodiment, the anode of the first pixel column may include an anode compensation portion 50-2.

As shown in FIG. 15A, the first anode 51 may include a first anode body portion 51-1 and a first anode connection portion 51-2. The first anode body portion 51-1 has a diamond-like shape. The first anode connection portion 51-2 has a strip shape extending in the second direction Y, and is connected to the first anode body portion 51-1. The first anode connection portion 51-2 is configured to be connected to a corresponding third connection electrode 43 through the eleventh via V11.

In an exemplary embodiment, the first anode connection portion 51-2 at the odd-numbered pixel column may be provided on a side of the first anode body portion 51-1 in a direction opposite to the second direction Y, and the first anode connection portion 51-2 at the even-numbered pixel column may be provided on a side of the first anode body portion 51-1 in the second direction Y.

In an exemplary embodiment, the first anode 51 may further include a first protrusion 71 that may have a strip shape extending in the second direction Y. A first end of the first protrusion 71 is connected to the first anode body portion 51-1, and a second end of the first protrusion 71 extends in a direction away from the first anode body portion 51-1.

In an exemplary embodiment, the first protrusion 71 may be provided on a side of the first anode body portion 51-1 away from the first anode connection portion 51-2. For example, the first protrusion 71 at the odd-numbered pixel column may be provided on a side of the first anode body portion 51-1 in the second direction Y, and the first protrusion 71 at the even-numbered pixel column may be provided on a side of the first anode body portion 51-1 in a direction opposite to the second direction Y.

In an exemplary embodiment, an orthographic projection of the first protrusion 71 on the base substrate at least partially overlaps an orthographic projection of the first scan signal line 21 and the gate block 21-1 on the base substrate, and the first protrusion 71 is configured to shield the second transistor T2, so as to improve the electrical performance of the second transistor T2, and improve the display quality and display effect.

In an exemplary embodiment, the first anode 51 at the odd-numbered pixel column may also include a second protrusion 72. The second protrusion 72 may have a strip shape extending in the first direction X, a first end of the second protrusion 72 is connected to the first anode body portion 51-1, and a second end of the second protrusion 72 extends in a direction away from the first anode body portion 51-1.

In an exemplary embodiment, the second protrusion 72 may be provided on a side of the first anode body portion 51-1 in a direction opposite to the first direction X. An orthographic projection of the second protrusion 72 on the base substrate at least partially overlaps an orthographic projection of the second connection electrode 42 and the first power supply line 45 in the previous row of circuit unit on the base substrate. The second protrusion 72 is configured to adjust planarization of the first anode 51 of the odd-numbered pixel row so that the traces of the third conductive layer below the anode side are as symmetrical as possible, and reduce luminance differences, thereby improving the display quality and display effect.

In an exemplary embodiment, the first anode 51 of the even-numbered pixel column may not be provided with the second protrusion 72.

In an exemplary embodiment, the first anode 51 of the odd-numbered pixel column may include a first anode compensation portion 81. An orthographic projection of the anode body portion of the first anode 51 of the odd-numbered pixel column on the base substrate does not overlap an orthographic projection of the first connection electrode on the base substrate. The first anode compensation portion 81 is configured so that a parasitic capacitance of the odd-numbered pixel column and a parasitic capacitance of the even-numbered pixel column are substantially the same.

In an exemplary embodiment, the first anode compensation portion 81 may have a polyline shape extending in the second direction Y, a first end of the first anode compensation portion 81 is connected to the first anode connection portion 51-2, and a second end of the first anode compensation portion 81 extends in a direction away from the first anode body portion 51-1 (a direction opposite to the second direction Y).

In an exemplary embodiment, an orthographic projection of the first anode compensation portion 81 on the base substrate at least partially overlaps orthographic projections of the electrode body portion 41-1 and the electrode compensation portion 41-2 in the first connection electrode 41 on the base substrate, or the orthographic projection of the first anode compensation portion 81 on the base substrate at least partially overlaps an orthographic projection of the electrode compensation portion 41-2 in the first connection electrode 41 on the base substrate. Since the first connection electrode 41 has the potential of the second node N2 in the pixel drive circuit and the first anode compensation portion 81 has the potential of the fourth node N4 in the pixel drive circuit, the first anode compensation portion 81 and the first connection electrode 41 may form a parasitic capacitance.

In an exemplary embodiment, the first anode of the even-numbered pixel column may not include the first anode compensation portion, and an orthographic projection of the anode body portion of the first anode of the even-numbered pixel column on the base substrate at least partially overlaps an orthographic projection of the first connection electrode on the base substrate.

In an exemplary embodiment, the first anode body portion 51-1, the first anode connection portion 51-2, the first protrusion 71, the second protrusion 72, and the first anode compensation portion 81 of the odd-numbered pixel column may be an interconnected integral structure, and the first anode body portion 51-1, the first anode connection portion 51-2, and the first protrusion 71 of the even-numbered pixel column may be an interconnected integral structure.

In an exemplary embodiment, the first overlapping area may include an overlapping area of the orthographic projection of the first anode compensation portion on the base substrate and the orthographic projection of the first connection electrode on the base substrate, and the second overlapping area may include an overlapping area of the orthographic projection of the first anode body portion on the base substrate and the orthographic projection of the first connection electrode on the base substrate. The orthographic projection of the first anode compensation portion of at least one light emitting unit in an odd-numbered pixel column on the base substrate and the orthographic projection of the first connection electrode on the base substrate have a first overlapping area, and the orthographic projection of the first anode body portion of at least one light emitting unit in an even-numbered pixel column on the base substrate and the orthographic projection of the first connection electrode on the base substrate have a second overlapping area. A ratio of the first overlapping area to the second overlapping area may be about 0.8 to 1.2.

As shown in FIG. 15B, the second anode 52 may include a second anode body portion 52-1 and a second anode connection portion 52-2. The second anode body portion 52-1 may have a hexagon-like shape, and the second anode connection portion 52-2 may have a strip shape extending in the second direction Y and is connected to the second anode body portion 52-1. The second anode connection portion 52-2 is configured to be connected to a corresponding third connection electrode 43 through the eleventh via V11.

In an exemplary embodiment, the second anode connection portion 52-2 of the odd-numbered pixel column may be provided on a side of the second anode body portion 52-1 in a direction opposite to the second direction Y, and the second anode connection portion 52-2 of the even-numbered pixel column may be provided on a side of the second anode body portion 52-1 in the second direction Y.

In an exemplary embodiment, the second anode 52 may further include a third protrusion 73 that may have a strip shape extending in the second direction Y. A first end of the third protrusion 73 is connected to the second anode body portion 52-1, and a second end of the third protrusion 73 extends in a direction away from the second anode body portion 52-1.

In an exemplary embodiment, the third protrusion 73 may be provided on a side of the second anode body portion 52-1 away from the second anode connection portion 52-2. For example, the third protrusion 73 of the odd-numbered pixel column may be provided on a side of the second anode body portion 52-1 in the second direction Y, and the third protrusion 73 of the even-numbered pixel column may be provided on a side of the second anode body portion 52-1 in a direction opposite to the second direction Y.

In an exemplary embodiment, an orthographic projection of the third protrusion 73 on the base substrate at least partially overlaps orthographic projections of the first scan signal line 21 and the gate block 21-1 on the base substrate, and the third protrusion 73 is configured to shield the second transistor T2, so as to improve the electrical performance of the second transistor T2, and improve the display quality and display effect.

In an exemplary embodiment, the second anode 52 of the odd-numbered pixel column may also include a fourth protrusion 74. The fourth protrusion 74 may have a strip shape extending in the first direction X, a first end of the fourth protrusion 74 is connected to the second anode body portion 52-1, and a second end of the fourth protrusion 74 extends in a direction away from the second anode body portion 52-1.

In an exemplary embodiment, the fourth protrusion 74 may be provided on a side of the second anode body portion 52-1 in a direction opposite to the first direction X. An orthographic projection of the fourth protrusion 74 on the base substrate at least partially overlaps orthographic projections of the second connection electrode 42 and the first power supply line 45 in the previous row of circuit unit on the base substrate. The fourth protrusion 74 is configured to adjust planarization of the second anode 52 so that the traces of the third conductive layer below the anode are as symmetrical as possible, and reduce luminance differences, thereby improving the display quality and display effect.

In an exemplary embodiment, the second anode 52 of the even-numbered pixel column may not be provided with the fourth protrusion 74.

In an exemplary embodiment, the second anode 52 of the odd-numbered pixel column may include a second anode compensation portion 82. An orthographic projection of the anode body portion of the second anode 52 of the odd-numbered pixel column on the base substrate does not overlap an orthographic projection of the first connection electrode on the base substrate. The second anode compensation portion 82 is configured so that a parasitic capacitance of the odd-numbered pixel column and a parasitic capacitance of the even-numbered pixel column are substantially the same.

In an exemplary embodiment, the second anode compensation portion 82 may have a polyline shape extending in the second direction Y, a first end of the second anode compensation portion 82 is connected to the second anode connection portion 52-2, and a second end of the second anode compensation portion 82 extends in a direction away from the second anode body portion 52-1 (a direction opposite to the second direction Y).

In an exemplary embodiment, an orthographic projection of the second anode compensation portion 82 on the base substrate at least partially overlaps orthographic projections of the electrode body portion 41-1 and the electrode compensation portion 41-2 in the first connection electrode 41 on the base substrate, or the orthographic projection of the second anode compensation portion 82 on the base substrate at least partially overlaps an orthographic projection of the electrode compensation portion 41-2 in the first connection electrode 41 on the base substrate. Since the first connection electrode 41 has the potential of the second node N2 in the pixel drive circuit and the second anode compensation portion 82 has the potential of the fourth node N4 in the pixel drive circuit, the second anode compensation portion 82 and the first connection electrode 41 may form a parasitic capacitance.

In an exemplary embodiment, the second anode of the even-numbered pixel column may not include the second anode compensation portion, and an orthographic projection of the anode body portion in the second anode of the even-numbered pixel column on the base substrate at least partially overlaps an orthographic projection of the first connection electrode on the base substrate.

In an exemplary embodiment, the second anode body portion 52-1, the second anode connection portion 52-2, the third protrusion 73, the fourth protrusion 74, and the second anode compensation portion 82 of the odd-numbered pixel column may be an interconnected integral structure, and the second anode body portion 52-1, the second anode connection portion 52-2, and the third protrusion 73 of the even-numbered pixel column may be an interconnected integral structure.

In an exemplary embodiment, the first overlapping area may include an overlapping area of the orthographic projection of the second anode compensation portion on the base substrate and the orthographic projection of the first connection electrode on the base substrate, and the second overlapping area may include an overlapping area of the orthographic projection of the second anode body portion on the base substrate and the orthographic projection of the first connection electrode on the base substrate. The orthographic projection of the second anode compensation portion of at least one light emitting unit at an odd-numbered pixel column on the base substrate and the orthographic projection of the first connection electrode on the base substrate have the first overlapping area, and the orthographic projection of the second anode body portion of at least one light emitting unit at an even-numbered pixel column on the base substrate and the orthographic projection of the first connection electrode on the base substrate have the second overlapping area. A ratio of the first overlapping area to the second overlapping area may be about 0.8 to 1.2.

As shown in FIG. 15C, the third anode 53 may include a third anode body portion 53-1 and a third anode connection portion 53-2. The third anode body portion 53-1 may have a hexagonal-like shape, and the third anode connection portion 53-2 may have a strip shape extending in the second direction Y and is connected to the third anode body portion 53-1. The third anode connection portion 53-2 is configured to be connected to a corresponding third connection electrode 43 through the eleventh via V11.

In an exemplary embodiment, the third anode connection portion 53-2 of the odd-numbered pixel column may be provided on a side of the third anode body portion 53-1 in a direction opposite to the second direction Y, and the third anode connection portions 53-2 of the even-numbered pixel column may be provided on a side of the third anode body portion 53-1 in the second direction Y.

In an exemplary embodiment, the third anode 53 may further include a fifth protrusion 75 that may have a strip shape extending in the second direction Y, a first end of the fifth protrusion 75 is connected to the third anode body portion 53-1, and a second end of the fifth protrusion 75 extends in a direction away from the third anode body portion 53-1.

In an exemplary embodiment, the fifth protrusion 75 may be provided on a side of the third anode body portion 53-1 away from the third anode connection 53-2. For example, the fifth protrusion 75 of the odd-numbered pixel column may be provided on a side of the third anode body portion 53-1 in the second direction Y, and the fifth protrusion 75 of the even-numbered pixel column may be provided on a side of the third anode body portion 53-1 in a direction opposite to the second direction Y.

In an exemplary embodiment, an orthographic projection of the fifth protrusion 75 on the base substrate at least partially overlaps orthographic projections of the first scan signal line 21 and the gate block 21-1 on the base substrate, and the fifth protrusion 75 is configured to shield the second transistor T2, so as to improve the electrical performance of the second transistor T2, and improve the display quality and display effect.

In an exemplary embodiment, the third anode 53 of the odd-numbered pixel column may further include a sixth protrusion 76. The sixth protrusion 76 may have a strip shape extending in the first direction X, a first end of the sixth protrusion 76 is connected to the third anode body portion 53-1, and a second end of the sixth protrusion 76 extends in a direction away from the third anode body portion 53-1.

In an exemplary embodiment, the sixth protrusion 76 may be provided on a side of the third anode body 53-1 in a direction opposite to the first direction X. An orthographic projection of the sixth protrusion 76 on the base substrate at least partially overlaps orthographic projections of the second connection electrode 42 and the first power supply line 45 in the previous row of circuit unit on the base substrate. The sixth protrusion 76 is configured to adjust planarization of the third anode 53 so that the traces of the third conductive layer below the anode are as symmetrical as possible, and luminance differences are reduced, thereby improving the display quality and display effect.

In an exemplary embodiment, the third anode 53 of the even-numbered pixel column may not be provided with the sixth protrusion 76.

In an exemplary embodiment, the third anode 53 of the odd-numbered pixel column may include a third anode compensation portion 83. An orthographic projection of the anode body portion of the third anode 53 of the odd-numbered pixel column on the base substrate does not overlap an orthographic projection of the first connection electrode on the base substrate. The third anode compensation portion 83 is configured so that a parasitic capacitance of the odd-numbered pixel column and a parasitic capacitance of the even-numbered pixel column are substantially the same.

In an exemplary embodiment, the third anode compensation portion 83 may have a polyline shape extending in the second direction Y, a first end of the third anode compensation portion 83 is connected to the third anode connection portion 53-2, and a second end of the third anode compensation portion 83 extends in a direction away from the third anode body portion 53-1 (a direction opposite to the second direction Y).

In an exemplary embodiment, an orthographic projection of the third anode compensation portion 83 on the base substrate at least partially overlaps orthographic projections of the electrode body portion 41-1 and the electrode compensation portion 41-2 in the first connection electrode 41 on the base substrate, or the orthographic projection of the third anode compensation portion 83 on the base substrate at least partially overlaps an orthographic projection of the electrode compensation portion 41-2 in the first connection electrode 41 on the base substrate. Since the first connection electrode 41 has the potential of the second node N2 in the pixel drive circuit and the third anode compensation portion 83 has the potential of the fourth node N4 in the pixel drive circuit, the third anode compensation portion 83 and the first connection electrode 41 may form a parasitic capacitance.

In an exemplary embodiment, the third anode of the even-numbered pixel column may not include the third anode compensation portion, and an orthographic projection of the anode body portion in the third anode of the even-numbered pixel column on the base substrate at least partially overlaps an orthographic projection of the first connection electrode on the base substrate.

In an exemplary embodiment, the third anode body portion 53-1, the third anode connection portion 53-2, the fifth protrusion 75, the sixth protrusion 76, and the third anode compensation portion 83 of the odd-numbered pixel column may be an interconnected integral structure, and the third anode body portion 53-1, the third anode connection portion 53-2, and the fifth protrusion 75 of the even-numbered pixel column may be an interconnected integral structure.

In an exemplary embodiment, the first overlapping area may include an overlapping area of the orthographic projection of the third anode compensation portion on the base substrate and the orthographic projection of the first connection electrode on the base substrate, and the second overlapping area may include an overlapping area of the orthographic projection of the third anode body portion on the base substrate and the orthographic projection of the first connection electrode on the base substrate. The orthographic projection of the third anode compensation portion of at least one light emitting unit in an odd-numbered pixel column on the base substrate and the orthographic projection of the first connection electrode on the base substrate have the first overlapping area, and the orthographic projection of the third anode body portion of at least one light emitting unit in an even-numbered pixel column on the base substrate and the orthographic projection of the first connection electrode on the base substrate have the second overlapping area. The ratio of the first overlapping area to the second overlapping area may be about 0.8 to 1.2.

Due to the characteristics of Delta pixel arrangement, the first anode of the odd-numbered pixel column and the first anode of the even-numbered pixel column are not on the same horizontal line, but the pixel drive circuit of the odd-numbered unit column and the pixel drive circuit of the even-numbered unit column are on the same horizontal line, so a corresponding region of the first anode of the odd-numbered pixel column and the pixel drive circuit is different from a corresponding region of the first anode of the even-numbered pixel column and the pixel drive circuit. The orthographic projection of the first anode of the odd-numbered pixel column on the base substrate at least partially overlaps the orthographic projections of the first transistor T1 and the seventh transistor T7 of the pixel drive circuit on the base substrate, and the orthographic projection of the first anode of the even-numbered pixel column on the base substrate at least partially overlaps the orthographic projections of the second transistor T2, the third transistor T3 and the storage capacitor of the pixel drive circuit on the base substrate. In addition, since the second anode of the odd-numbered pixel column and the second anode of the even-numbered pixel column are not on the same horizontal line, a corresponding region of the second anode of the odd-numbered pixel column and the pixel drive circuit is different from a corresponding region of the second anode of the even-numbered pixel column and the pixel drive circuit. Since the third anode of the odd-numbered pixel column and the third anode of the even-numbered pixel column are not on the same horizontal line, a corresponding region of the third anode of the odd-numbered pixel column and the pixel drive circuit is different from a corresponding region of the third anode of the even-numbered pixel column and the pixel drive circuit.

In an exemplary embodiment, the anode body portion of the even-numbered pixel column is located in a region where the storage capacitor is located, and the orthographic projection of the anode body portion of the even-numbered pixel column on the base substrate at least partially overlaps the orthographic projection of the first connection electrode 41 on the base substrate. A distance between the anode body portion of odd-numbered pixel column and the storage capacitor is greater, and the orthographic projection of the anode body portion of the odd-numbered pixel column on the base substrate does not overlap the orthographic projection of the first connection electrode 41 on the base substrate, so that for the parasitic capacitance formed by the second node N2 and the fourth node N4, the parasitic capacitance of the even-numbered pixel column is greater than that of the odd-numbered pixel column. It is found in the research that in a light emitting initial stage of a pixel, a potential of the fourth node N4 will increase with the increase of luminance, which thereby will bring a potential of the second node N2 to increase. When the parasitic capacitance of the odd-numbered pixel column is different from the parasitic capacitance of the even-numbered pixel column, the increasing degree of the potential of the second node N2 of the odd-numbered pixel column is different from the increasing degree of the potential of the second node N2 of the even-numbered pixel column, so that the luminance of the light emitting unit of the odd-numbered pixel column is different from the luminance of the light emitting unit of the even-numbered pixel column, resulting in a display defect with vertical stripes.

The display substrate provided by an exemplary embodiment of the present disclosure effectively reduces a difference between the parasitic capacitance of the first pixel column and the parasitic capacitance of the second pixel column through the first connection electrode including the electrode compensation portion. In one aspect, in the present disclosure the anode of the first pixel column includes an anode compensation portion extending in a direction of the first connection electrode, and the orthographic projection of the anode compensation portion on the base substrate at least partially overlaps the orthographic projection of the first connection electrode on the base substrate, thereby the parasitic capacitance of the first pixel column is increased, and a difference between the parasitic capacitance of the first pixel column and the parasitic capacitance of the second pixel column is reduced. On another aspect, in the present disclosure the first connection electrode of the first pixel column includes an electrode compensation portion extending in a direction of the anode, and the orthographic projection of the electrode compensation portion on the base substrate at least partially overlaps the orthographic projection of the anode compensation portion on the base substrate, the parasitic capacitance of the first pixel column is further increased and the difference between the parasitic capacitance of the first pixel column and the parasitic capacitance of the second pixel column is further reduced. The present disclosure effectively reduces the difference between the parasitic capacitance of the first pixel column and the parasitic capacitance of the second pixel column by providing the electrode compensation portion and the anode compensation portion, so that the parasitic capacitance of the first pixel column and the parasitic capacitance of the second pixel column are substantially the same, thereby effectively eliminating the display defect with vertical stripes, and improving the display quality and the display effect. The manufacturing process in the present disclosure can be compatible well with an existing manufacturing process, is simple in process implementation, is easy to implement, and has a high production efficiency, a low production cost, and a high yield.

In an exemplary embodiment, a subsequent manufacturing process may include: forming a pattern of a pixel definition layer that may at least include a plurality of pixel openings exposing the anode, forming an organic light emitting layer using an evaporation or inkjet printing process, wherein the organic light emitting layer is connected to an anode through a pixel opening, and forming a cathode on the organic light emitting layer, wherein the cathode is connected to the organic light emitting layer; forming an encapsulation structure layer that may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is arranged between the first encapsulation layer and the third encapsulation layer, so that it can be ensured that external water vapor cannot enter a light emitting structure layer.

The aforementioned structure shown in the present disclosure and the manufacturing process thereof are merely exemplary description. In an exemplary embodiment, corresponding structures may be changed and patterning processes may be added or reduced according to actual needs, which is not limited here in the present disclosure.

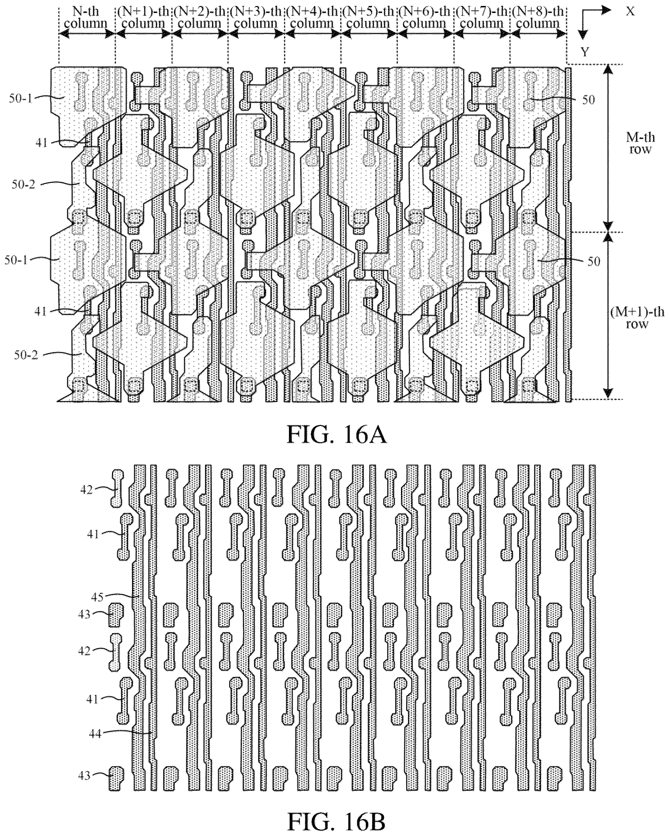

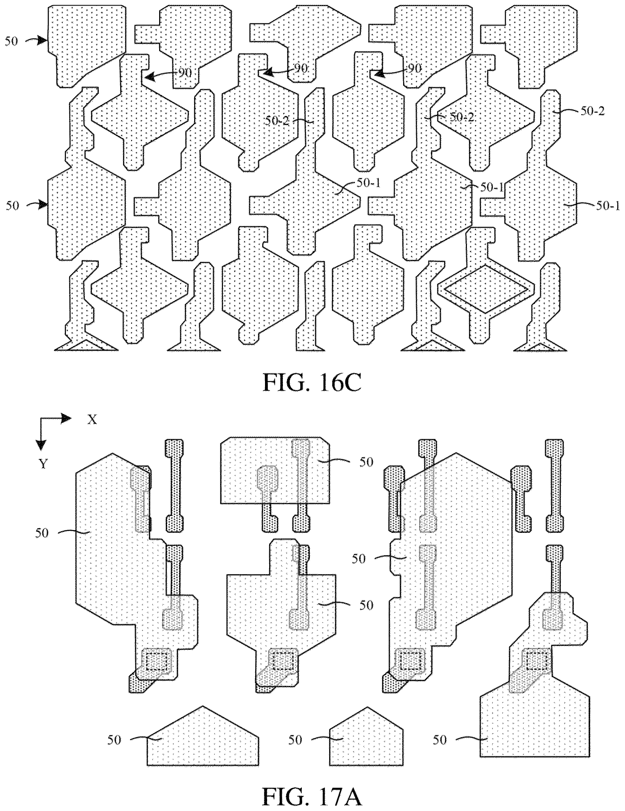

FIG. 16A is a schematic diagram of a structure of another display substrate according to an exemplary embodiment of the present disclosure, FIG. 16B is a planar schematic diagram of the third conductive layer in FIG. 16A, and FIG. 16C is a planar schematic diagram of the anode conductive layer in FIG. 16A. In an exemplary embodiment, a structure of the display substrate of the present embodiment is substantially the same as that of the display substrate shown in FIG. 7, except that the first connection electrode portion in the drive circuit layer is not provided with an electrode compensation portion, and the anode of the light emitting structure layer is provided with an anode compensation portion and a compensation notch, respectively.

As shown in FIGS. 16A, 16B, and 16C, a structure of the drive circuit layer of the present embodiment is substantially the same as that of the drive circuit layer of the foregoing embodiment, except that the first connection electrode 41 only includes an electrode body portion and no electrode compensation portion is provided. A structure of the light emitting structure layer of the present embodiment is substantially the same as that of the light emitting structure layer of the foregoing embodiment, except that the anode 50 not only includes an anode body portion 50-1 and an anode compensation portion 50-2, but also is provided with a compensation notch 90.

In an exemplary embodiment, an orthographic projection of the anode body portion of at least one light emitting unit in the first pixel column on the base substrate does not overlap an orthographic projection of the first connection electrode 41 on the base substrate, and an orthographic projection of the anode body portion of at least one light emitting unit in the second pixel column on the base substrate at least partially overlaps an orthographic projection of the first connection electrode 41 on the base substrate.

In an exemplary embodiment, the anode of at least one light emitting unit in the first pixel column may include an anode body portion 50-1 and an anode compensation portion 50-2. Structures of the anode body portion 50-1 and the anode compensation portion 50-2 are substantially the same as those of the foregoing embodiments. An orthographic projection of the anode compensation portion 50-2 on the base substrate at least partially overlaps an orthographic projection of the first connection electrode 41 on the base substrate.

In an exemplary embodiment, the anode of at least one light emitting unit in the second pixel column may be provided with a compensation notch 90 configured to compensate for a parasitic capacitance between the second node N2 and the fourth node N4 in the pixel drive circuit to eliminate a difference between a parasitic capacitance of the pixel drive circuit in an odd-numbered unit column and a parasitic capacitance of the pixel drive circuit in an even-numbered unit column. In an exemplary embodiment, the compensation notch 90 is configured to reduce an overlapping area of the first connection electrode (second node N2) of the second pixel column and the first connection electrode (fourth node N4), thereby reducing the parasitic capacitance between the second node N2 and the fourth node N4, such that the parasitic capacitance of the odd-numbered column is substantially the same as that of the even-numbered column.

In an exemplary embodiment, the compensation notch 90 in the second pixel column may be provided on the anode body portion 50-1, and the compensation notch 90 may be a groove provided on the anode body portion 50-1. An orthographic projection of the groove on the base substrate at least partially overlaps an orthographic projection of the first connection electrode on the base substrate.

In another exemplary embodiment, the compensation notch 90 in the second pixel column may be provided on a protrusion. The anode of at least one light emitting unit in the second pixel column may include an anode body portion 50-1, an anode connection portion and a protrusion. The protrusion may be provided on a side of the anode body portion 50-1 away from the anode connection portion. A first end of the protrusion is connected to the anode body portion, and a second end of the protrusion extends in a direction away from the anode body portion. An orthographic projection of the protrusion on the base substrate at least partially overlaps an orthographic projection of the first connection electrode on the base substrate. The compensation notch 90 may be provided on the protrusion. The compensation notch 90 may be a groove provided on the protrusion, and an orthographic projection of the groove on the base substrate at least partially overlaps the orthographic projection of the first connection electrode on the base substrate.

In yet another exemplary embodiment, the compensation notch 90 in the second pixel column may be a region where a portion of the anode (e.g., a protruding portion or an extending portion) is narrowed relative to an adjacent portion, the narrowed region has no anode conductive thin film, but is directly adjacent to the anode.

In yet another exemplary embodiment, the compensation notch 90 in the second pixel column may be a region inward recessed from an anode boundary, the recessed region has no anode conductive thin film but is directly adjacent to the anode.

According to the display substrate provided by the exemplary embodiment of the present disclosure, on one aspect, the parasitic capacitance of the first pixel column is increased by providing an anode compensation portion on the anode of the first pixel column, and on another aspect, the parasitic capacitance of the second pixel column is reduced by providing a compensation notch on the anode of the second pixel column, which is equivalent to digging out a part of an area of the anode, thereby reducing a difference between the parasitic capacitance of the first pixel column and the parasitic capacitance of the second pixel column, enabling the parasitic capacitance of the first pixel column and the parasitic capacitance of the second pixel column to be substantially the same, effectively eliminating the display defect with vertical strips, and improving the display quality and display effect.

In an exemplary embodiment, the present disclosure further provides another display substrate, the structure of which is substantially the same as that of the display substrate of the foregoing embodiments, except that an electrode compensation portion is provided in the first connection electrode, and an anode compensation portion and a compensation notch are respectively provided in the anode. The structures of the electrode compensation portion, the anode compensation portion and the compensation notch are substantially the same as those of the foregoing embodiments, which will not be described here.

According to the display substrate provided by the exemplary embodiment of the present disclosure, on one aspect, the parasitic capacitance of the first pixel column is increased by providing an anode compensation portion on the anode of the first pixel column, and on another aspect, the parasitic capacitance of the first pixel column is increased by providing an electrode compensation portion on the first connection electrode of the first pixel column, and on still another aspect, the parasitic capacitance of the second pixel column is reduced by providing a compensation notch on the anode of the second pixel column, thereby minimizing the difference between the parasitic capacitance of the first pixel column and the parasitic capacitance of the second pixel column, enabling the parasitic capacitance of the first pixel column and the parasitic capacitance of the second pixel column to be substantially the same, eliminating the display defect with vertical strips, and improving the display quality and display effect.

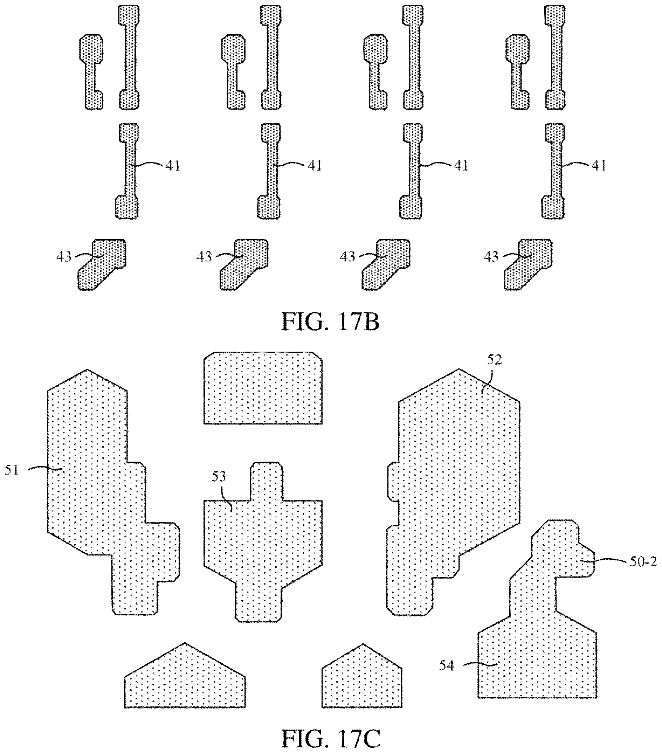

FIG. 17A is a schematic diagram of a structure of yet another display substrate according to an exemplary embodiment of the present disclosure, FIG. 17B is a planar schematic diagram of the third conductive layer in FIG. 17A, and FIG. 17C is a planar schematic diagram of the anode conductive layer in FIG. 17A, illustrating a GGRB pixel arrangement. As shown in FIGS. 17A, 17B, and 17C, the drive circuit layer may at least include a first connection electrode 41 and a third connection electrode 43, and the light emitting structure layer may include a plurality of anodes 50.

In an exemplary embodiment, the first connection electrode 41 may have a strip shape extending in the second direction Y, a first end of the first connection electrode 41 is connected to a first electrode plate of the storage capacitor through a via, a second end of the first connection electrode 41 is connected to a first region of the second active layer through a via, and the first connection electrode 41 may serve as the second node N2 in the pixel drive circuit.

In an exemplary embodiment, the third connection electrode 43 may have a polygonal shape, the third connection electrode 43 is connected to the second electrode of the sixth transistor and the second electrode of the seventh transistor through a via, and the third connection electrode 43 may serve as the fourth node N4 in the pixel drive circuit.

In an exemplary embodiment, the plurality of anodes 50 may at least include a first anode 51 of a red light emitting unit, a second anode 52 of a blue light emitting unit, a fourth anode 54 of a first green light emitting unit, and a fifth anode 55 of a second green light emitting unit. A region where the first anode 51 is located may form a red light emitting unit R that emits red light, a region where the second anode 52 is located may form a blue light emitting unit B that emits blue light, a region where the fourth anode 54 is located may form a first green light emitting unit G1 that emits green light, and a region where the fifth anode 55 is located may form a second green light emitting unit G2 that emits green light. The red light emitting unit R and the blue light emitting unit B may be sequentially provided in the first direction X, and the first green light emitting unit G1 and the second green light emitting unit G2 may be sequentially provided in the second direction Y. In the first direction X, the first green light emitting unit G1 and the second green light emitting unit G2 may be provided between the red light emitting unit R and the blue light emitting unit B to form a GGRB arrangement.

In an exemplary embodiment, the positional relationship between the four anodes and the circuit units may be different, a main body portion of the fourth anode 54 is located on a side of the corresponding connection circuit unit in the second direction Y, and a main body portion of the fifth anode 55 is located in a circuit unit of the next row of the corresponding connection circuit unit. Since the circuit units corresponding to the fourth anode 54 and the fifth anode 55 are not on the same horizontal line, for a parasitic capacitance formed by the anode and the first connection electrode, the parasitic capacitance of the first green light emitting unit G1 is greatly different from the parasitic capacitance of the second green light emitting unit G2.

In an exemplary embodiment, the anode may include an anode body portion and an anode connection portion, and the anode connection portion is configured to be connected to the third connection electrode 43 in the corresponding circuit unit through a via. An orthographic projection of the anode body portion of the fourth anode 54 of the first green light emitting unit G1 on the base substrate at least partially overlaps an orthographic projection of the first connection electrode 41 on the base substrate, and an orthographic projection of the anode body portion of the fifth anode 55 of the second green light emitting unit G2 on the base substrate does not overlap an orthographic projection of the first connection electrode 41 on the base substrate.

In an exemplary embodiment, the fifth anode 55 of the second green light emitting unit G2 may further include an anode compensation portion 50-2. A first end of the anode compensation portion 50-2 is connected to the anode connection portion of the fifth anode 55, and a second end of the anode compensation portion 50-2 extends in a direction away from the anode body portion. An orthographic projection of the anode compensation portion 50-2 on the base substrate at least partially overlaps the orthographic projection of the first connection electrode 41 on the base substrate. An orthographic projection of the fourth anode 54 on the base substrate has a first overlapping area with the orthographic projection of the first connection electrode 41 on the base substrate, and an orthographic projection of the anode compensation portion 50-2 of the fifth anode 55 on the base substrate has a second overlapping area with the orthographic projection of the first connection electrode 41 on the base substrate. A ratio of the first overlapping area to the second overlapping area may be about 0.8 to 1.2

In another exemplary embodiment, the fifth anode of the second green light emitting unit G2 may further include an anode compensation portion, and the first connection electrode in the circuit unit connected to the fifth anode may further include an electrode compensation portion. An orthographic projection of the electrode compensation portion on the base substrate at least partially overlaps an orthographic projection of the anode compensation portion on the base substrate. An orthographic projection of the fourth anode on the base substrate has a first overlapping area with the orthographic projection of the first connection electrode on the base substrate, and an orthographic projection of the anode compensation portion of the fifth anode on the base substrate has a second overlapping area with an orthographic projection of the electrode compensation portion of the first connection electrode on the base substrate. A ratio of the first overlapping area to the second overlapping area may be about 0.9 to 1.1.

In yet another exemplary embodiment, the fifth anode of the second green light emitting unit G2 may further include an anode compensation portion, and the fourth anode of the first green light emitting unit G1 may further be provided with a compensation notch. An orthographic projection of the compensation notch on the base substrate at least partially overlaps the orthographic projection of the first connection electrode on the base substrate, and the compensation notch is configured to reduce an overlapping area of the fourth anode and the first connection electrode. An orthographic projection of the fourth anode on the base substrate has a first overlapping area with the orthographic projection of the first connection electrode on the base substrate, and an orthographic projection of the anode compensation portion of the fifth anode on the base substrate has a second overlapping area with the orthographic projection of the first connection electrode on the base substrate. A ratio of the first overlapping area to the second overlapping area may be about 0.9 to 1.1.

In yet another exemplary embodiment, the fifth anode of the second green light emitting unit G2 may further include an anode compensation portion, and the fourth anode of the first green light emitting unit G1 may further be provided with a compensation notch. An orthographic projection of the compensation notch on the base substrate at least partially overlaps the orthographic projection of the first connection electrode on the base substrate. The circuit unit connected to the fifth anode may further include an electrode compensation portion. An orthographic projection of the electrode compensation portion on the base substrate at least partially overlaps an orthographic projection of the anode compensation portion on the base substrate. An orthographic projection of the fourth anode on the base substrate has a first overlapping area with the orthographic projection of the first connection electrode on the base substrate, and an orthographic projection of the anode compensation portion of the fifth anode on the base substrate has a second overlapping area with an orthographic projection of the electrode compensation portion of the first connection electrode on the base substrate. A ratio of the first overlapping area to the second overlapping area may be about 0.9 to 1.1.

The display substrate provided by the exemplary embodiment of the present disclosure can effectively reduce a difference between the parasitic capacitance of the first green light emitting unit and the parasitic capacitance of the second green light emitting unit, can enable the parasitic capacitance of the first green light emitting unit to be substantially the same as the parasitic capacitance of the second green light emitting unit, and can not only ensure the consistency of green luminance, but also eliminate the defect with vertical strips under the full gray scale, thereby improving the display quality and display effect.

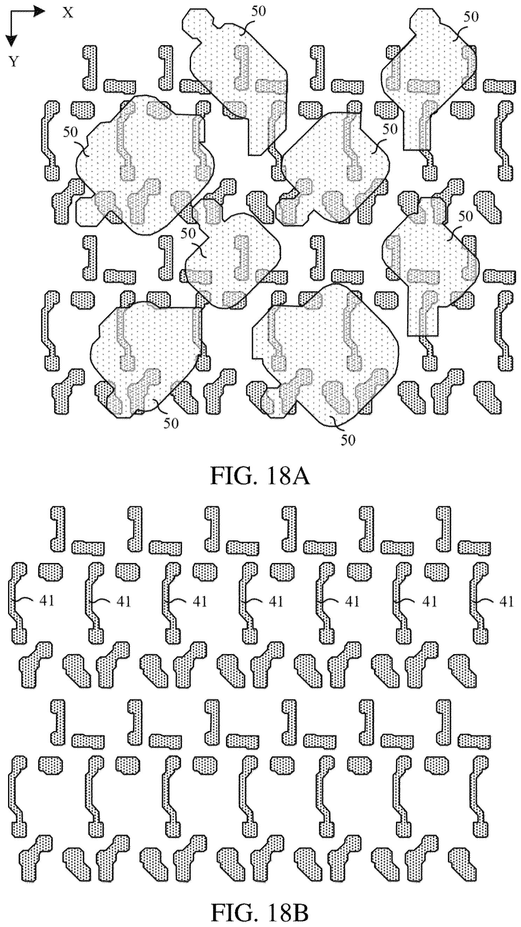

FIG. 18A is a schematic diagram of a structure of still another display substrate according to an exemplary embodiment of the present disclosure, and FIG. 18B is a planar schematic diagram of the third conductive layer in FIG. 18A, illustrating a Magic pixel arrangement. As shown in FIGS. 18A and 18B, the drive circuit layer may at least include a first connection electrode 41, and the light emitting structure layer may include a plurality of anodes 50.

In an exemplary embodiment, the first connection electrode 41 may have a strip shape extending in the second direction Y, a first end of the first connection electrode 41 is connected to a first electrode plate of the storage capacitor through a via, a second end of the first connection electrode 41 is connected to a first region of the second active layer through a via, and the first connection electrode 41 may serve as the second node N2 in the pixel drive circuit.

In an exemplary embodiment, the plurality of anodes 50 may at least include a first anode 51 of a red light emitting unit, a second anode 52 of a blue light emitting unit, a fourth anode 54 of a first green light emitting unit, and a fifth anode 55 of a second green light emitting unit. A region where the first anode 51 is located may form a red light emitting unit R that emits red light, a region where the second anode 52 is located may form a blue light emitting unit B that emits blue light, a region where the fourth anode 54 is located may form a first green light emitting unit G1 that emits green light, and a region where the fifth anode 55 is located may form a second green light emitting unit G2 that emits green light. The red light emitting unit R, the first green light emitting unit G1, the blue light emitting unit B and the second green light emitting unit G2 may be sequentially provided in the first direction X. The red light emitting unit R and the blue light emitting unit B are located on a first horizontal line, and the first green light emitting unit G1 and the second green light emitting unit G2 are located on a second horizontal line. The second horizontal line is located on a side of the first horizontal line in the second direction Y. The red light emitting unit R, the blue light emitting unit B, the first green light emitting unit G1 and the second green light emitting unit G2 form a Magic pixel arrangement.

In an exemplary embodiment, the anode may include an anode body portion and an anode connection portion. The anode connection portion is configured to be connected to a third connection electrode in a corresponding circuit unit through a via, so that the anode may serve as a fourth node N4 in the pixel drive circuit. The anode body portions of the fourth anode 54 and the fifth anode 55 may have a shape of a rectangle, long sides of the rectangle are deflected by a certain angle with respect to the second direction Y, and a deflection direction of the fourth anode 54 is opposite to that of the fifth anode 55. Therefore, although the circuit units corresponding to the fourth anode 54 and the fifth anode 55 are on the same horizontal line, since the deflection directions of the fourth anode 54 and the fifth anode 55 are different, for a parasitic capacitance formed by the anode and the first connection electrode, the parasitic capacitance of the first green light emitting unit G1 is greatly different from the parasitic capacitance of the second green light emitting unit G2

In an exemplary embodiment, at least one of the fourth anode 54 an the fifth anode 55 may include an anode compensation portion, and an orthographic projection of the anode compensation portion on the base substrate at least partially overlaps the orthographic projection of the first connection electrode on the base substrate. In another exemplary embodiment, the corresponding circuit unit may include an electrode compensation portion, and an orthographic projection of the electrode compensation portion on the base substrate at least partially overlaps the orthographic projection of the anode compensation portion on the base substrate. In yet another exemplary embodiment, one anode may include an anode compensation portion, and another anode may be provided with a compensation notch. In yet another exemplary embodiment, a corresponding circuit unit may include an electrode compensation portion, one anode may include an anode compensation portion, and another anode may be provided with a compensation notch.

The display substrate provided by the exemplary embodiment of the present disclosure can effectively reduce a difference between the parasitic capacitance of the first green light emitting unit and the parasitic capacitance of the second green light emitting unit, can enable the parasitic capacitance of the first green light emitting unit to be substantially the same as the parasitic capacitance of the second green light emitting unit, and can not only ensure the consistency of green luminance, but also eliminate the defect with vertical strips under the full gray scale, thereby improving the display quality and display effect.

The present disclosure further provides a manufacturing method for a display substrate, for manufacturing the display substrate provided by the foregoing embodiments. In an exemplary embodiment, the manufacturing method may include: forming a drive circuit layer on a base substrate, wherein the drive circuit layer includes a plurality of circuit units, the circuit unit at least includes a pixel drive circuit, the pixel drive circuit at least includes a storage capacitor and a compensation transistor, a first electrode of the compensation transistor is connected to a first electrode plate of the storage capacitor through a first connection electrode, and first connection electrodes of at least two circuit units have different shapes; and forming a light emitting structure layer on the drive circuit layer, wherein the light emitting structure layer includes a plurality of light emitting units, the light emitting unit at least includes an anode, and the anode is connected to the pixel drive circuit; and an orthographic projection of the anode of at least one light emitting unit on the base substrate at least partially overlaps an orthographic projection of the first connection electrode of at least one circuit unit on the base substrate.

The present disclosure also provides a display device including the aforementioned display substrate. The display device may be any product or component with a display function, such as a mobile phone, a tablet computer, a television, a display, a laptop computer, a digital photo frame, or a navigator, which is not limited in the embodiments of the present invention.

Although the implementations disclosed in the present disclosure are described as above, the described contents are only implementations which are used for facilitating the understanding of the present disclosure, but are not intended to limit the present invention. Any skilled person in the art to which the present disclosure pertains may make any modifications and variations in forms and details of implementations without departing from the spirit and scope of the present disclosure. However, the patent protection scope of the present invention should be subject to the scope defined by the appended claims.

**Claims**

1. A display substrate, comprising a drive circuit layer provided on a base substrate, and a light emitting structure layer provided on a side of the drive circuit layer away from the base substrate; wherein the drive circuit layer comprises a plurality of circuit units, a circuit unit at least comprises a pixel drive circuit, the pixel drive circuit at least comprises a storage capacitor and a compensation transistor, a first electrode of the compensation transistor is connected to a first electrode plate of the storage capacitor through a first connection electrode; the light emitting structure layer comprises a plurality of light emitting units, a light emitting unit at least comprise an anode, and the anode is connected to the pixel drive circuit; an orthographic projection of the anode of at least one light emitting unit on the base substrate at least partially overlaps an orthographic projection of the first connection electrode of at least one circuit unit on the base substrate, and first connection electrodes of at least two circuit units have different shapes.

2.  The display substrate according to claim 1, wherein the first connection electrode comprises an electrode body portion and an electrode compensation portion, the electrode body portion comprises a first end connected to the first electrode plate of the storage capacitor, and a second end connected to the first electrode of the compensation transistor, the electrode compensation portion is provided on a side of the first end away from the second end; electrode body portions of at least two circuit units have a same shape, and electrode compensation portions of at least two circuit units have different shapes.

3.  The display substrate according to claim 2, wherein a plurality of circuit units form a plurality of unit rows and a plurality of unit columns, an unit row comprises a plurality of circuit units sequentially provided in a first direction, an unit column comprises a plurality of circuit units sequentially provided in a second direction, the first direction intersects the second direction; and in at least one unit column, first connection electrodes of at least two circuit units have a same shape.

4.  The display substrate according to claim 3, wherein in at least one unit row, the plurality of circuit units at least comprise a first circuit unit, a second circuit unit and a third circuit unit, a pixel drive circuit of the first circuit unit is connected to a red light emitting unit emitting red light, a pixel drive circuit of the second circuit unit is connected to a blue light emitting unit emitting blue light, a pixel drive circuit of the third circuit unit is connected to a green light emitting unit emitting green light, and first connection electrodes in the first circuit unit, the second circuit unit, and the third circuit unit have different shapes.

5.  The display substrate according to claim 4, wherein electrode body portions in the first circuit unit, the second circuit unit, and the third circuit unit have a same shape, and electrode compensation portions in the first circuit unit, the second circuit unit, and the third circuit unit have different shapes.

6.  The display substrate according to claim 4, wherein a first connection electrode of the first circuit unit has a first length, a first connection electrode of the second circuit unit has a second length, and a first connection electrode of the third circuit unit has a third length; the first length, the second length and the third length are different, and the first length, the second length and the third length are dimensions of first connection electrodes in the second direction.

7.  The display substrate according to claim 6, wherein the second length is greater than the first length, and the second length is greater than the third length.

8.  The display substrate according to claim 6, wherein the third length is greater than the first length.

9.  The display substrate according to any one of claims 1 to 8, wherein the anode of at least one light emitting unit comprises an anode body portion, an anode connection portion and an anode compensation portion, the anode connection portion is configured to be connected to the pixel drive circuit, and the anode compensation portion is provided on a side of the anode connection portion away from the anode body portion.

10. The display substrate according to claim 9, wherein in at least one circuit unit, an orthographic projection of the anode compensation portion on the base substrate at least partially overlaps an orthographic projection of the electrode compensation portion of the first connection electrode on the base substrate.

11. The display substrate according to claim 9, wherein in at least one circuit unit, an orthographic projection of the anode compensation portion on the base substrate at least partially overlaps an orthographic projection of the electrode body portion of the first connection electrode on the base substrate.

12. The display substrate according to claim 9, wherein in at least one circuit unit, an orthographic projection of the anode body portion on the base substrate at least partially overlaps an orthographic projection of the first connection electrode on the base substrate.

13. The display substrate according to claim 9, wherein in at least one circuit unit, an orthographic projection of the anode body portion on the base substrate does not overlap an orthographic projection of the first connection electrode on the base substrate.

14. The display substrate according to claim 9, wherein in at least one circuit unit, the anode is provided with a compensation notch configured to reduce an overlapping area of the anode and the first connection electrode.

15. The display substrate according to claim 14, wherein the anode further comprises a protrusion provided on a side of the anode body portion away from the anode connection portion, an orthographic projection of the protrusion on the base substrate at least partially overlaps an orthographic projection of the first connection electrode on the base substrate, and the compensation notch is provided on the protrusion.

16. The display substrate according to claim 15, wherein the compensation notch comprises a groove provided on an edge of the protrusion, and an orthographic projection of the groove on the base substrate at least partially overlaps an orthographic projection of the first connection electrode on the base substrate.

17. The display substrate according to any one of claims 1 to 8, wherein on a plane perpendicular to the display substrate, the drive circuit layer comprises a semiconductor layer, a first conductive layer, a second conductive layer and a third conductive layer that are sequentially provided on the base substrate; the semiconductor layer at least comprises an active layer of the compensation transistor, the first conductive layer at least comprises the first electrode plate of the storage capacitor and a gate electrode of the compensation transistor, and the second conductive layer at least comprises the second electrode plate of the storage capacitor, and the third conductive layer at least comprises the first connection electrode.

18. A display device, comprising a display substrate according to any one of claims 1 to 17.

19. A manufacturing method for a display substrate, comprising:

forming a drive circuit layer on a base substrate, wherein the drive circuit layer comprises a plurality of circuit units, a circuit unit at least comprises a pixel drive circuit, the pixel drive circuit at least comprises a storage capacitor and a compensation transistor, a first electrode of the compensation transistor is connected to a first electrode plate of the storage capacitor through a first connection electrode, and first connection electrodes of at least two circuit units have different shapes; and
forming a light emitting structure layer on the drive circuit layer, wherein the light emitting structure layer comprises a plurality of light emitting units, a light emitting unit at least comprises an anode, and the anode is connected to the pixel drive circuit; and an orthographic projection of the anode of at least one light emitting unit on the base substrate at least partially overlaps an orthographic projection of the first connection electrode of at least one circuit unit on the base substrate.

FIG. 1

FIG. 2

FIG. 3

FIG. 4

FIG. 5

PB

FIG. 6

N-th
column (N+1)-th
column (N+2)-th
column (N+3)-th
column (N+4)-th
column (N+5)-th
column (N+6)-th
column (N+7)-th
column (N+8)-th
column

X

Y

50-1

41-1

41-2

50-2

50-1

41-1

41-2

50-2

50

41

40

50

41

40

M-th
row

(M+1)-th
row

FIG. 7

FIG. 8

FIG. 9A

FIG. 9B

FIG. 10A

FIG. 10B

FIG. 11

N-th column | (N+1)-th column | (N+2)-th column | (N+3)-th column | (N+4)-th column | (N+5)-th column | (N+6)-th column | (N+7)-th column | (N+8)-th column

## FIG. 12A

## FIG. 12B

N-th column | (N+1)-th column | (N+2)-th column | (N+3)-th column | (N+4)-th column | (N+5)-th column | (N+6)-th column | (N+7)-th column | (N+8)-th column

X

Y

T7

T1

T2

T3

M-th row

T6

V11

(M+1)-th row

## FIG. 13

N-th column | (N+1)-th column | (N+2)-th column | (N+3)-th column | (N+4)-th column | (N+5)-th column | (N+6)-th column | (N+7)-th column | (N+8)-th column

X

Y

T7

T1

T2

T3

M-th row

T6

T5

(M+1)-th row

## FIG. 14A

FIG. 14B

FIG. 15A

FIG. 15B

FIG. 15C

FIG. 16A

FIG. 16B

FIG. 16C

FIG. 17A

FIG. 17B

FIG. 17C

FIG. 18A

FIG. 18B

## INTERNATIONAL SEARCH REPORT

| International application No. |
|---|
| **PCT/CN2022/110849** |

### A. CLASSIFICATION OF SUBJECT MATTER

H01L 27/32(2006.01)i

According to International Patent Classification (IPC) or to both national classification and IPC

### B. FIELDS SEARCHED

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

WPI, EPODOC, CNPAT, CNKI: display, array, substrate, anode, electrode, compensat+, transistor, TFT, overlap+, parasitic, storage, capacitor, 显示, 阵列, 基板, 阳极, 电极, 补偿, 晶体管, 重叠, 重合, 寄生, 存储, 电容, 竖纹

### C. DOCUMENTS CONSIDERED TO BE RELEVANT

| Category* | Citation of document, with indication, where appropriate, of the relevant passages | Relevant to claim No. |
|---|---|---|
| X | WO 2021217993 A1 (BOE TECHNOLOGY GROUP CO., LTD. et al.) 04 November 2021 (2021-11-04)<br>description, page 8, line 25-page 20, line 5, and figures 1-7 | 1-19 |
| A | CN 113763883 A (BOE TECHNOLOGY GROUP CO., LTD. et al.) 07 December 2021 (2021-12-07)<br>entire document | 1-19 |
| A | CN 110690360 A (SHANGHAI TIANMA ORGANIC LIGHT EMITTING DISPLAY TECHNOLOGY CO., LTD.) 14 January 2020 (2020-01-14)<br>entire document | 1-19 |
| A | CN 111681549 A (KUNSHAN GOVISIONOX OPTOELECTRONICS CO., LTD.) 18 September 2020 (2020-09-18)<br>entire document | 1-19 |
| A | US 2015053931 A1 (SAMSUNG DISPLAY CO., LTD.) 26 February 2015 (2015-02-26)<br>entire document | 1-19 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **09 December 2022** | **20 December 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2022/110849**

| Patent document cited in search report | | | Publication date (day/month/year) | Patent family member(s) | | | Publication date (day/month/year) |
|---|---|---|---|---|---|---|---|
| WO | 2021217993 | A1 | 04 November 2021 | US | 2022320226 | A1 | 06 October 2022 |
| | | | | US | 2022320247 | A1 | 06 October 2022 |
| | | | | WO | 2021217295 | A1 | 04 November 2021 |
| | | | | WO | 2021217994 | A1 | 04 November 2021 |
| | | | | CN | 114097090 | A | 25 February 2022 |
| CN | 113763883 | A | 07 December 2021 | WO | 2021238486 | A1 | 02 December 2021 |
| | | | | EP | 4002478 | A1 | 25 May 2022 |
| CN | 110690360 | A | 14 January 2020 | CN | 110690360 | B | 17 June 2022 |
| CN | 111681549 | A | 18 September 2020 | CN | 111681549 | B | 18 March 2022 |
| US | 2015053931 | A1 | 26 February 2015 | JP | 2015041102 | A | 02 March 2015 |
| | | | | KR | 20150021818 | A | 03 March 2015 |
| | | | | US | 9293482 | B2 | 22 March 2016 |
| | | | | JP | 6552161 | B2 | 31 July 2019 |
| | | | | KR | 102114315 | B1 | 25 May 2020 |

Form PCT/ISA/210 (patent family annex) (January 2015)